(19) Europäisches Patentamt
European Patent Office
Office européen des brevets

(11) **EP 4 580 326 A1**

(12) **EUROPEAN PATENT APPLICATION**
published in accordance with Art. 153(4) EPC

(43) Date of publication:
**02.07.2025  Bulletin 2025/27**

(21) Application number: **23905587.4**

(22) Date of filing: **21.11.2023**

(51) International Patent Classification (IPC):
***H05K 7/20*** (2006.01)

(52) Cooperative Patent Classification (CPC):
**H02M 7/00; H02M 7/42; H02S 40/32; H05K 7/20**

(86) International application number:
**PCT/CN2023/132920**

(87) International publication number:
**WO 2024/131418 (27.06.2024 Gazette 2024/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.12.2022  CN 202223453727 U**

(71) Applicant: **Huawei Digital Power Technologies
Co., Ltd.
Shenzhen, Guangdong 518043 (CN)**

(72) Inventors:
• **TANG, Tingting
  Shenzhen, Guangdong 518043 (CN)**
• **LI, Jiyang
  Shenzhen, Guangdong 518043 (CN)**
• **ZHANG, Weilong
  Shenzhen, Guangdong 518043 (CN)**

(74) Representative: **Isarpatent
Patent- und Rechtsanwälte
Barth Hassa Peckmann & Partner mbB
Friedrichstraße 31
80801 München (DE)**

(54) **HEAT DISSIPATION APPARATUS, POWER MODULE, POWER SUPPLY SYSTEM, VEHICLE, AND PHOTOVOLTAIC SYSTEM**

(57)     A heat dissipation apparatus (5), a power assembly (4), a power supply system (1), a vehicle (2), and a photovoltaic system (3) are provided. The heat dissipation apparatus (5) includes a bottom plate (500), and a first heat dissipation device (510) and a second heat dissipation device (520) that are stacked on a first surface (501) of the bottom plate (500), the first heat dissipation device (510) is located between the first surface (501) and the second heat dissipation device (520), and a second surface (502) of the bottom plate (500) is used to fasten a power module (42), to dissipate heat for the power module (42). A plurality of first heat dissipation pillars (511) spaced apart are disposed in the first heat dissipation device (510), a plurality of second heat dissipation pillars (521) spaced apart are disposed in the second heat dissipation device (520), and a flow rate in first heat dissipation channels (K1) between all the first heat dissipation pillars (511) in the first heat dissipation device (510) is greater than a flow rate in second heat dissipation channels (K2) between all the second heat dissipation pillars (521) in the second heat dissipation device (520). The heat dissipation apparatus (5) is used, so that a cooling medium can have a large flow rate and high heat transfer efficiency on a side that is of the heat dissipation apparatus (5) and that is close to a power device (420), thereby helping improve cooling effect of the heat dissipation apparatus (5).

FIG. 4

## Description

This application claims priority to Chinese Patent Application No. 202223453727.4, filed with the China National Intellectual Property Administration on December 22, 2022 and entitled "HEAT DISSIPATION APPARATUS, POWER ASSEMBLY, POWER SUPPLY SYSTEM, VEHICLE, AND PHOTOVOLTAIC SYSTEM", which is incorporated herein by reference in its entirety.

## TECHNICAL FIELD

This application relates to the field of semiconductor technologies, and in particular, to a heat dissipation apparatus, a power assembly, a power supply system, a vehicle, and a photovoltaic system.

## BACKGROUND

Power assemblies play an important role in the new energy industry, and are core components in the fields such as new energy vehicles and smart photovoltaics. An operating power device in a power assembly is frequently switched between a turn-on state and a turn-off state, and implements conversion between an alternating current voltage and a direct current voltage by switching between the two states, to provide a proper voltage for a load. However, frequent state switching causes a heat loss of the power assembly, including a turn-on loss and a turn-off loss. Both the turn-on loss and the turn-off loss bring a large amount of heat to the power assembly, and a high temperature causes a decrease in conversion efficiency of the power assembly or even causes damage to the power assembly. The power assembly serves as a core component of a power supply system, and the decrease in conversion efficiency of the power assembly and the damage to the power assembly greatly affect the entire power supply system.

To reduce a temperature of the operating power assembly, a heat dissipation apparatus is usually mounted in the power assembly, and a cooling medium flows into the heat dissipation apparatus to exchange heat with a power device that generates heat. However, a problem that different parts of a heat dissipation apparatus currently used in a power assembly generate different amounts of heat is not considered, resulting in poor cooling effect of the heat dissipation apparatus on the power assembly.

## SUMMARY

This application provides a heat dissipation apparatus that can improve cooling effect on a power module, a power assembly, a power supply system, a vehicle, and a photovoltaic system.

According to a first aspect, this application provides a heat dissipation apparatus. The heat dissipation apparatus includes a bottom plate, a first heat dissipation device, and a second heat dissipation device, the bottom plate includes a first surface and a second surface that are disposed opposite to each other, the first heat dissipation device and the second heat dissipation device are stacked on the first surface in a thickness direction of the bottom plate, the first heat dissipation device is located between the first surface and the second heat dissipation device, and the second surface is configured to fasten a power module, to dissipate heat for the power module. A plurality of first heat dissipation pillars spaced apart are disposed in the first heat dissipation device, a plurality of second heat dissipation pillars spaced apart are disposed in the second heat dissipation device, and after a cooling medium flows into the first heat dissipation device and the second heat dissipation device, a flow rate in first heat dissipation channels between all the first heat dissipation pillars in the first heat dissipation device is greater than a flow rate in second heat dissipation channels between all the second heat dissipation pillars in the second heat dissipation device.

One of functions of the bottom plate is to fasten the first heat dissipation device and the second heat dissipation device. To be specific, the first surface of the bottom plate is connected to the first heat dissipation device, the bottom plate, the first heat dissipation device, and the second heat dissipation device are stacked in the thickness direction of the bottom plate, and the thickness direction of the bottom plate is defined as a first direction. Another function of the bottom plate is to transfer heat from the power module to the heat dissipation apparatus. To be specific, the second surface of the bottom plate is fastened to the power module, and heat generated by a power device in the power module is transferred to the second surface of the bottom plate through a metal layer-clad substrate, and then is in contact with the first heat dissipation device and the second heat dissipation device through the first surface of the bottom plate. In an implementation, the second surface of the bottom plate is welded to the power module through solder, and the bottom plate is made of a thermally conductive material. This helps reduce thermal resistance of the heat dissipation apparatus.

The first heat dissipation device and the second heat dissipation device are configured to: connect to a cooling system, and transmit a cooling medium provided by the cooling system. When heat is transferred from the power module to the heat dissipation apparatus, the cooling medium in the first heat dissipation device and the second heat dissipation device exchanges heat with the power module, and the heat dissipation apparatus takes the heat away from the power module, to reduce a temperature of the power device in a steady working state, and control a temperature of the power module. In this implementation, the cooling medium is non-conductive pure water. In some other implementations, the cooling medium may be any one of fluoride, methyl silicone oil, silicone oil, and mineral oil.

In this implementation, the plurality of first heat dissipation pillars are spaced apart in the first heat dissipation device, and the plurality of second heat dissipation pillars are spaced apart in the second heat dissipation device. In this way, the first heat dissipation pillars and the second heat dissipation pillars can increase a contact area between the heat dissipation apparatus and the cooling medium, to enhance turbulence of the cooling medium, and improve a surface heat transfer coefficient.

In addition, if a solution in which a plurality of through holes are disposed in the heat dissipation apparatus is used, flow channels of the cooling medium in the heat dissipation apparatus are isolated by the through holes and are independent of each other. Consequently, heat exchange effect is limited. However, in this application, the first heat dissipation pillars divide the first heat dissipation device into the first heat dissipation channels that are connected to each other, the second heat dissipation pillars divide the second heat dissipation device into the second heat dissipation channels that are connected to each other, and gaps between the first heat dissipation pillars and gaps between the second heat dissipation pillars form heat dissipation channels; and when the cooling medium flows into the gaps between the first heat dissipation pillars, the cooling medium may flow into a gap between any two adjacent first heat dissipation pillars, and when the cooling medium flows into the gaps between the second heat dissipation pillars, the cooling medium may flow into a gap between any two adjacent second heat dissipation pillars. In this way, flow channels of the cooling medium in the heat dissipation apparatus are connected to each other. This helps reduce flow resistance of the cooling medium, and improves heat dissipation efficiency.

In this implementation, because the first heat dissipation device is connected to the first surface of the bottom plate, and the second surface of the bottom plate is connected to the power module, the first heat dissipation device is closer to the power module than the second heat dissipation device. In addition, because the power module generates a large amount of heat when the power module is in a working state, a temperature of the first heat dissipation device closer to the power module is higher than a temperature of the second heat dissipation device.

If only one heat dissipation device is disposed in the heat dissipation apparatus, a side that is of the heat dissipation device and that is close to the power module has a high temperature and large thermal resistance. Alternatively, if two or more heat dissipation devices with a same space volume are stacked in the heat dissipation apparatus, a heat dissipation condition of a heat dissipation device close to the power module is poor due to local overheating, and overall cooling efficiency of the heat dissipation apparatus is also affected.

In this implementation, the flow rate in the first heat dissipation channels between all the first heat dissipation pillars in the first heat dissipation device is set to be greater than the flow rate in the second heat dissipation channels between all the second heat dissipation pillars in the second heat dissipation device, and flow resistance of the cooling medium is small, so that cooling effect of the first heat dissipation device is stronger, and the first heat dissipation device is cooperated with the second heat dissipation device. This helps the heat dissipation apparatus conduct heat, and improves overall heat dissipation effect of the heat dissipation apparatus. The first heat dissipation channels between all the first heat dissipation pillars are a sum of the gaps between all the first heat dissipation pillars, and the second heat dissipation channels between all the second heat dissipation pillars are a sum of the gaps between all the second heat dissipation pillars.

In this application, the heat dissipation apparatus is disposed in a power assembly. First, the first heat dissipation pillars and the second heat dissipation pillars increase a contact area between the cooling medium and the first heat dissipation device and a contact area between the cooling medium and the second heat dissipation device, thereby helping improve heat exchange efficiency.

Second, the first heat dissipation pillars divide the first heat dissipation device into mutually connected flow channels, and the second heat dissipation pillars divide the second heat dissipation device into mutually connected flow channels, so that flow resistance of the cooling medium in the first heat dissipation device and the second heat dissipation device is small.

Third, the first heat dissipation pillars and the second heat dissipation pillars are configured to: after the cooling medium flows into the first heat dissipation device and the second heat dissipation device, enable a flow rate in the first heat dissipation device to be greater than a flow rate in the second heat dissipation device, so that a larger flow rate in the first heat dissipation device can take away more heat transmitted by the power module to the bottom plate, thereby improving cooling effect of the heat dissipation apparatus on the power module. The flow rate in the first heat dissipation channels between all the first heat dissipation pillars in the first heat dissipation device is set to be greater than the flow rate in the second heat dissipation channels between all the second heat dissipation pillars in the second heat dissipation device, so that a flow velocity and the flow rate of the cooling medium are larger in the first heat dissipation device. In this way, a heat dissipation capability of the heat dissipation apparatus on a side adjacent to the power module is improved, thereby helping improve cooling effect of the heat dissipation apparatus on the power module.

In a possible implementation, fluid resistance of all the first heat dissipation pillars in the first heat dissipation device is less than fluid resistance of all the second heat dissipation pillars in the first heat dissipation device. Smaller fluid resistance may indicate smaller resistance endured by the cooling medium during flowing and a larger flow rate in the first heat dissipation device. This helps improve cooling effect of the first heat dissipation device.

Fluid resistance is resistance endured by an object from a fluid when the object moves relative to the fluid in the fluid (a liquid or a gas). In this implementation, fluid resistance of the first heat dissipation pillar is resistance endured by the first heat dissipation pillar from the cooling medium when the first heat dissipation pillar moves relative to the cooling medium in the cooling medium; and fluid resistance of the second heat dissipation pillar is resistance endured by the second heat dissipation pillar from the cooling medium when the second heat dissipation pillar moves relative to the cooling medium in the cooling medium.

In this implementation, shapes of the first heat dissipation pillar and the second heat dissipation pillar are set, so that the fluid resistance of the first heat dissipation pillar is less than the fluid resistance of the second heat dissipation pillar.

In a possible implementation, a sum of volumes of the first heat dissipation channels between all the first heat dissipation pillars is greater than a sum of volumes of the second heat dissipation channels between all the second heat dissipation pillars.

In this implementation, the first heat dissipation channels and the second heat dissipation channels are configured to allow the cooling medium to circulate. The volumes of the first heat dissipation channels between all the first heat dissipation pillars in the first heat dissipation device are set to be greater than the volumes of the second heat dissipation channels between all the second heat dissipation pillars in the second heat dissipation device, so that after the cooling medium flows into the first heat dissipation device and the second heat dissipation device, the flow rate in the first heat dissipation device is greater than the flow rate in the second heat dissipation device. In some implementations, the volumes of the first heat dissipation channels between all the first heat dissipation pillars in the first heat dissipation device may alternatively be set to be less than or equal to the volumes of the second heat dissipation channels between all the second heat dissipation pillars in the second heat dissipation device. However, more complex structures and arrangement manners of the first heat dissipation pillars and the second heat dissipation pillars need to be designed, so that the flow rate in the first heat dissipation device is greater than the flow rate in the second heat dissipation device. In this implementation, to simplify a process, the volumes of the first heat dissipation channels are set to be greater than the volumes of the second heat dissipation channels.

In this implementation, the volumes of the first heat dissipation channels are set to be greater than the volumes of the second heat dissipation channels. Because the first heat dissipation channels are larger, the cooling medium has smaller flow resistance and a larger flow rate in the first heat dissipation channels, so that the first heat dissipation device has stronger cooling effect, and the first heat dissipation device is cooperated with the second heat dissipation device. This helps the heat dissipation apparatus conduct heat, and improves overall heat dissipation effect of the heat dissipation apparatus.

In a possible implementation, the first heat dissipation device includes a plurality of first heat dissipation pillars located at an edge, and the second heat dissipation device includes a plurality of second heat dissipation pillars located at an edge; the plurality of first heat dissipation pillars located at the edge of the first heat dissipation device one-to-one correspond to the plurality of second heat dissipation pillars located at the edge of the second heat dissipation device, and each first heat dissipation pillar is at least partially aligned with a corresponding second heat dissipation pillar; and a length of the first heat dissipation device in the thickness direction of the bottom plate is greater than a length of the second heat dissipation device in the thickness direction of the bottom plate.

In this implementation, an area enclosed by first heat dissipation pillars located at an outermost edge of the first heat dissipation device is equal to an area enclosed by second heat dissipation pillars located at an outermost edge of the second heat dissipation device, and the length of the first heat dissipation device in the first direction is set to be greater than the length of the second heat dissipation device in the first direction, so that the volumes of the first heat dissipation channels between all the first heat dissipation pillars in the first heat dissipation device are greater than the volumes of the second heat dissipation channels between all the second heat dissipation pillars in the second heat dissipation device. In this way, the flow rate and a flow velocity of the cooling medium in the first heat dissipation device are greater than the flow rate and a flow velocity of the cooling medium in the second heat dissipation device. This helps improve cooling effect of the first heat dissipation device, and improves a temperature distribution status of the heat dissipation apparatus.

In a possible implementation, the first heat dissipation pillar and the second heat dissipation pillar have a same cross-sectional area, and a quantity of first heat dissipation pillars is the same as a quantity of second heat dissipation pillars. In this case, the volumes of the first heat dissipation channels between all the first heat dissipation pillars in the first heat dissipation device can be greater than the volumes of the second heat dissipation channels between all the second heat dissipation pillars in the second heat dissipation device only by setting the length of the first heat dissipation device in the first direction to be greater than the length of the second heat dissipation device in the first direction. This solution helps reduce manufacturing difficulty of the heat dissipation apparatus.

In a possible implementation, a length of the first heat dissipation pillar in the thickness direction of the bottom plate is greater than a length of the second heat dissipation pillar in the thickness direction of the bottom plate.

In this implementation, the length of the first heat dissipation pillar in the first direction is greater than the length of the second heat dissipation pillar in the first direction, and both a cross section of the first heat dissipation device and a cross section of the second heat dissipation device are perpendicular to the first direction. In this implementation, the length of the first heat dissipation pillar in the first direction is greater than the length of the second heat dissipation pillar in the first direction. It may be understood that, when the cooling medium flows into the first heat dissipation device, both an inner wall of the first heat dissipation device and outer surfaces of the first heat dissipation pillars are in contact with the cooling medium. Therefore, a larger length of the first heat dissipation pillar in the first direction indicates a larger contact area between the first heat dissipation pillar and the cooling medium and better flow disturbing effect of the first heat dissipation pillar on the cooling medium. This helps improve cooling effect of the first heat dissipation device.

In a possible implementation, a spacing between every two first heat dissipation pillars in the first heat dissipation device is greater than a spacing between every two second heat dissipation pillars in the second heat dissipation device. In this implementation, a second direction is parallel to the first surface of the bottom plate, and perpendicularly intersects the first direction.

The spacing between every two first heat dissipation pillars in the first heat dissipation device may be a spacing in the second direction, or may be a spacing in any direction parallel to the first surface.

In this implementation, the spacing between every two first heat dissipation pillars is a spacing between the two first heat dissipation pillars in the second direction, and the spacing between every two second heat dissipation pillars is a spacing between the two second heat dissipation pillars in the second direction. The spacing between every two first heat dissipation pillars is set to be greater than the spacing between every two second heat dissipation pillars, so that the volumes of the first heat dissipation channels between all the first heat dissipation pillars in the first heat dissipation device are greater than the volumes of the second heat dissipation channels between all the second heat dissipation pillars in the second heat dissipation device. In this way, flow resistance of the cooling medium between every two first heat dissipation pillars is less than flow resistance of the cooling medium between every two second heat dissipation pillars. This helps increase a flow velocity of the cooling medium in the first heat dissipation device. In addition, a higher flow velocity of the cooling medium indicates better heat exchange effect, thereby properly distributing the cooling medium in the first heat dissipation device and the second heat dissipation device.

In this implementation, a length of the first heat dissipation device in the second direction is the same as a length of the second heat dissipation device in the second direction. In this case, distribution density of the first heat dissipation pillars in the first heat dissipation device is less than distribution density of the second heat dissipation pillars in the second heat dissipation device, and a smaller space volume occupied by the first heat dissipation pillars in the first heat dissipation device indicates larger volumes of the first heat dissipation channels through which the cooling medium flows. Therefore, flow resistance of the first heat dissipation device is smaller, and cooling effect of the first heat dissipation device is improved.

In a possible implementation, an area of a cross section of the first heat dissipation pillar is less than an area of a cross section of the second heat dissipation pillar, and both the cross section of the first heat dissipation pillar and the cross section of the second heat dissipation pillar are perpendicular to the thickness direction of the bottom plate.

Both the cross section of the first heat dissipation pillar and the cross section of the second heat dissipation pillar are parallel to the second direction and the first surface of the bottom plate. Two end faces of the first heat dissipation pillar in the first direction have a same shape and a same area, and two end faces of the second heat dissipation pillar in the first direction have a same shape and a same area. For example, the first heat dissipation pillar and the second heat dissipation pillar are square pillars and cylinders. It should be noted that a same shape and a same area herein are not limited to being absolutely the same, and may be understood as being basically the same, and a case in which shapes and areas are not absolutely the same due to factors such as an assembly tolerance, a design tolerance, and structural flatness is allowed.

In this implementation, when an area of a cross section of the first heat dissipation device is equal to an area of a cross section of the second heat dissipation device, the area of the cross section of the first heat dissipation pillar is set to be less than the area of the cross section of the second heat dissipation pillar, so that a spacing between every two first heat dissipation pillars is larger, and the volumes of the first heat dissipation channels through which the cooling medium flows are larger. This helps reduce flow resistance of the cooling medium in the first heat dissipation device. When the area of the cross section of the first heat dissipation device is not equal to the area of the cross section of the second heat dissipation device, the area of the cross section of the first heat dissipation pillar is set to be less than the area of the cross section of the second heat dissipation pillar, so that a flow volume of the cooling medium in the first heat dissipation device is larger.

In a possible implementation, a volume of the first heat dissipation pillar is less than a volume of the second heat dissipation pillar. In this implementation, the volume of the first heat dissipation pillar is set to be less than the volume of the second heat dissipation pillar, so that the volumes of the first heat dissipation channels through which the cooling medium flows in the first heat dissipation device are greater than the volumes of the second heat dissipation channels through which the cooling medium flows in the second heat dissipation device, thereby effectively improving cooling efficiency of the cooling medium in the first heat dissipation device.

In a possible implementation, two end faces of the first heat dissipation pillar in the first direction are different, and two end faces of the second heat dissipation pillar in the first direction are different. Specifically, there may be the following three cases, and the first heat dissipation pillar is used as an example for description. In a first case, the two end faces of the first heat dissipation pillar in the first direction have a same shape but different areas. For example, the first heat dissipation pillar is a cylindrical table pillar. In a second case, the two end faces of the first heat dissipation pillar in the first direction have different shapes but a same area. For example, the first heat dissipation pillar is chopstick-shaped. In a third case, the two end faces of the first heat dissipation pillar in the first direction have different shapes and different areas. For example, the first heat dissipation pillar is a conical pillar, a triangular pillar, an olive shape, an ellipsoid shape, an hourglass shape, a dumbbell shape, a water droplet shape, or an irregular shape. The foregoing implementation may adapt to different application scenarios, so that the heat dissipation apparatus is more diversified.

In a possible implementation, a quantity of first heat dissipation pillars is less than a quantity of second heat dissipation pillars. The quantity of first heat dissipation pillars is set to be less than the quantity of second heat dissipation pillars, so that distribution density of the first heat dissipation pillars in the first heat dissipation device can be less than distribution density of the second heat dissipation pillars in the second heat dissipation device. When the cooling medium separately flows into the first heat dissipation device and the second heat dissipation device, the cooling medium encounters less blockage from the first heat dissipation pillars and fewer collisions between the first heat dissipation pillars and the cooling medium, so that the cooling medium flows more smoothly in the first heat dissipation device. This helps the cooling medium fully utilize heat dissipation effect.

In a possible implementation, the first heat dissipation pillar and the second heat dissipation pillar have a same shape, a total volume of internal space of the first heat dissipation device is equal to a total volume of internal space of the second heat dissipation device, and a quantity of first heat dissipation pillars is less than a quantity of second heat dissipation pillars. In this way, distribution density of the first heat dissipation pillars in the first heat dissipation device is less than distribution density of the second heat dissipation pillars in the second heat dissipation device. When the cooling medium separately flows into the first heat dissipation device and the second heat dissipation device, the cooling medium encounters less blockage from the first heat dissipation pillars and fewer collisions between the first heat dissipation pillars and the cooling medium, so that the cooling medium flows more smoothly in the first heat dissipation device. This helps the cooling medium fully utilize heat dissipation effect.

In a possible implementation, an orthographic projection of at least one of the plurality of first heat dissipation pillars on the first surface and an orthographic projection of at least one of the plurality of second heat dissipation pillars on the first surface are staggered.

In this implementation, space in which the cooling medium exchanges heat is the first heat dissipation channels between all the first heat dissipation pillars in the first heat dissipation device and the second heat dissipation channels between all the second heat dissipation pillars in the second heat dissipation device, and the first heat dissipation pillars and the second heat dissipation pillars have a higher heat conduction capability than the cooling medium. In this application, an orthographic projection of at least one first heat dissipation pillar on the first surface and an orthographic projection of at least one second heat dissipation pillar on the first surface are set to be staggered, and the gaps between the first heat dissipation pillars partially overlap the second heat dissipation pillars, so that heat of the cooling medium in the gaps between the first heat dissipation pillars (or the first heat dissipation channels) can be transmitted upward to the second heat dissipation pillars. In this way, the second heat dissipation device can assist the first heat dissipation device in cooling, thereby improving cooling efficiency of the first heat dissipation device. Staggering means non-overlapping or incomplete overlapping.

In a possible implementation, an orthographic projection of each of the plurality of first heat dissipation pillars on the first surface and an orthographic projection of each of the plurality of second heat dissipation pillars on the first surface are staggered. This solution helps further improve heat conduction effect.

In a possible implementation, the plurality of first heat dissipation pillars and the plurality of second heat dissipation pillars are all regularly arranged. In an implementation, the plurality of first heat dissipation pillars and the plurality of second heat dissipation pillars are regularly arranged, and at least one first heat dissipation pillar and one second heat dissipation pillar are staggered. When the plurality of first heat dissipation pillars and the plurality of second heat dissipation pillars are regularly arranged, and the at least one first heat dissipation pillar and one second heat dissipation pillar are staggered, it indicates that an arrangement rule of the plurality of first heat dissipation pillars and an arrangement rule of the plurality of second heat dissipation pillars are different. In this way, the cooling medium in the first heat dissipation channels can transfer heat to the second heat dissipation pillars located above the first heat dissipation channels, and the second heat dissipation pillars directly absorb the heat in the first direction. This shortens a heat transfer path, and helps improve efficiency of heat exchange between the cooling medium in the first heat dissipation channels and the cooling medium in the second heat dissipation channels.

In a possible implementation, that the plurality of first heat dissipation pillars are regularly arranged means that the plurality of first heat dissipation pillars include a plurality of groups of first heat dissipation pillars arranged in a third direction, each group of first heat dissipation pillars includes a plurality of first heat dissipation pillars arranged at intervals in a fourth direction, the third direction intersects the fourth direction, and both the third direction and the fourth direction intersect the first direction.

In a possible implementation, that the plurality of second heat dissipation pillars are regularly arranged means that the plurality of second heat dissipation pillars include a plurality of groups of second heat dissipation pillars arranged in a fifth direction, each group of second heat dissipation pillars includes a plurality of second heat dissipation pillars arranged at intervals in a sixth direction, the fifth direction intersects the sixth direction, and both the fifth direction and the sixth direction intersect the first direction.

In a possible implementation, the third direction intersects the fifth direction, and the fourth direction intersects the sixth direction. In this implementation, because the first heat dissipation device, the second heat dissipation device, and the bottom plate are stacked, the third direction, the fourth direction, the fifth direction, and the sixth direction are all parallel to the first surface of the bottom plate. In this solution, the third direction is set to intersect the fifth direction, and the fourth direction is set to intersect the sixth direction, so that the first heat dissipation pillars and the second heat dissipation pillars are arranged in different manners, and the orthographic projection of the first heat dissipation pillar on the first surface and the orthographic projection of the second heat dissipation pillar on the first surface are staggered, thereby improving cooling efficiency of the second heat dissipation device and the first heat dissipation device.

In some other implementations, the plurality of first heat dissipation pillars and the plurality of second heat dissipation pillars may alternatively be arranged according to another rule. For example, the plurality of first heat dissipation pillars and the plurality of second heat dissipation pillars may be distributed in a radial shape or a concentric circle, provided that it is ensured that the orthographic projection of at least one of the first heat dissipation pillars on the first surface and the orthographic projection of at least one of the second heat dissipation pillars on the first surface are staggered.

In a possible implementation, a quantity of first heat dissipation pillars in a group of first heat dissipation pillars first increases and then decreases in the third direction, so that all the first heat dissipation pillars form a square as a whole. Similarly, a quantity of second heat dissipation pillars in a group of second heat dissipation pillars first increases and then decreases in the third direction, so that all the second heat dissipation pillars form a square as a whole.

In a possible implementation, the heat dissipation apparatus further includes a liquid inlet and a liquid outlet, the liquid inlet and the liquid outlet are respectively located on two sides of the first heat dissipation device and the second heat dissipation device in a seventh direction, and the seventh direction intersects the third direction, the fourth direction, the fifth direction, and the sixth direction, so that after the cooling medium enters the first heat dissipation device and the second heat dissipation device, a degree of mixing of the cooling medium is higher, thereby improving heat dissipation effect.

In a possible implementation, the heat dissipation apparatus further includes a top plate, a partition plate, and a side frame that are located on one side of the first surface, the partition plate is disposed between the top plate and the first surface in the thickness direction of the bottom plate, the side frame surrounds a peripheral side of the partition plate, one end of the side frame in the thickness direction of the bottom plate is sealed with the first surface, and the other end of the side frame in the thickness direction of the bottom plate is sealed with the top plate; and the first heat dissipation device is located in space enclosed by the bottom plate, the partition plate, and a part that is of the side frame and that is between the bottom plate and the partition plate, and the second heat dissipation device is located in space enclosed by the partition plate, the top plate, and a part that is of the side frame and that is between the partition plate and the top plate.

In this implementation, the first heat dissipation pillars are located between the first surface and the partition plate, and the second heat dissipation pillars are located between the partition plate and the top plate. The top plate forms a part of the second heat dissipation device, and the top plate is connected to the second heat dissipation pillars. This helps prevent the cooling medium from leaking from the top of fins of the second heat dissipation pillars, improves utilization of the cooling medium, and enhances heat dissipation effect.

In this implementation, the partition plate separately forms a part of the first heat dissipation device and a part of the second heat dissipation device, and the partition plate is configured to partition the heat dissipation apparatus into the first heat dissipation device and the second heat dissipation device.

In this implementation, two ends of the side frame are respectively sealed with the top plate and the first surface in the first direction. This helps enhance stability of the heat dissipation apparatus, and ensures that the cooling medium is not affected by an external environment and stably functions in the heat dissipation apparatus. In an implementation, the side frame is sealed with the top plate and the first surface through welding.

In a possible implementation, the heat dissipation apparatus includes a water channel bottom cover;

the top plate, the second heat dissipation pillars, the partition plate, and the first heat dissipation pillars are all located in the water channel bottom cover; and the water channel bottom cover is in a groove shape, and an opening end of the water channel bottom cover is sealed with the first surface through welding. The side frame is a peripheral part of the water channel bottom cover. In this solution, the water channel bottom cover is disposed in the heat dissipation apparatus, to help prevent the cooling medium from leaking from the top of fins of the second heat dissipation pillars.

In a possible implementation, the side frame is the water channel bottom cover, and penetrates the water channel bottom cover in the first direction, and two ends of the water channel bottom cover are respectively sealed with the top plate and the first surface through welding. A material of the water channel bottom cover may be different from a material of the top plate and a material of the partition plate. In this solution, the side frame is disposed as a part of the water channel bottom cover, so that the water channel bottom cover can cooperate with the top plate to jointly prevent the cooling medium from leaking from the heat dissipation apparatus, thereby improving utilization of the cooling medium by the heat dissipation apparatus, and improving cooling effect.

In a possible implementation, the heat dissipation apparatus is not additionally provided with a water channel bottom cover, the side frame is welded to the top plate and the first surface, and a material of the side frame is the same as a material of the top plate and a material of the partition plate. In this solution, manufacturing costs of the heat dissipation apparatus are reduced while ensuring that the cooling medium is not prone to leak.

In a possible implementation, the first heat dissipation pillars and the bottom plate are of an integrally formed structure, and the second heat dissipation pillars and the partition plate are of an integrally formed structure; or the first heat dissipation pillars, the partition plate, and the second heat dissipation pillars are of an integrally formed structure.

In this implementation, the integrally formed structure can effectively improve stability of the heat dissipation apparatus, so that the first heat dissipation pillars and the second heat dissipation pillars in the heat dissipation apparatus do not shake in a process of cooling the power module. In addition, the integrally formed structure helps reduce processing difficulty and manufacturing costs of the heat dissipation apparatus.

In a possible implementation, the liquid inlet and the liquid outlet of the heat dissipation apparatus are located on two sides of the side frame in the seventh direction. The liquid inlet and the liquid outlet are connected to an external cooling system, and are configured to: input an external cooling medium into the heat dissipation apparatus through the liquid inlet, and output the external cooling medium through the liquid outlet. A high-temperature cooling medium flowing out of the liquid outlet is cooled by the external cooling system and then flows into the heat dissipation apparatus again through the liquid inlet. There may be one or more liquid inlets and liquid outlets. This may be specifically set based on a requirement.

In a possible implementation, the heat dissipation apparatus further includes a third heat dissipation device, a plurality of third heat dissipation pillars spaced apart are disposed in the third heat dissipation device, the third heat dissipation device is located on a side that is of the second heat dissipation device and that is away from the bottom plate, and after the cooling medium flows into the second heat dissipation device and the third heat dissipation device, the flow rate in the second heat dissipation channels between all the second heat dissipation pillars in the second heat dissipation device is greater than a flow rate in third heat dissipation channels between all the third heat dissipation pillars in the third heat dissipation device.

In this implementation, the third heat dissipation channels are configured to allow the cooling medium to circulate, and volumes of the third heat dissipation channels are less than the volumes of the second heat dissipation channels. The volumes of the third heat dissipation channels are set to be less than the volumes of the second heat dissipation channels, so that after the cooling medium flows into the second heat dissipation device and the third heat dissipation device, a flow rate in the third heat dissipation device is less than the flow rate in the second heat dissipation device.

In a possible implementation, the fluid resistance of the second heat dissipation pillar is less than fluid resistance of the third heat dissipation pillar.

In this implementation, the fluid resistance of the third heat dissipation pillar is resistance endured by the third heat dissipation pillar from the cooling medium when the third heat dissipation pillar moves relative to the cooling medium in the cooling medium. Shapes of the second heat dissipation pillar and the third heat dissipation pillar are set, so that the fluid resistance of the second heat dissipation pillar is less than the fluid resistance of the third heat dissipation pillar.

In this implementation, to implement that the volumes of the third heat dissipation channels other than the third heat dissipation pillars in the third heat dissipation device are less than the volumes of the second heat dissipation channels other than the second heat dissipation pillars in the second heat dissipation device, the following structural parameters may be set: a length of the third heat dissipation device in the first direction, a length of the third heat dissipation pillar in the first direction, a spacing between third heat dissipation pillars, an area of a cross section of the third heat dissipation pillar, a volume of the third heat dissipation pillar, a quantity of third heat dissipation pillars, an arrangement manner of the third heat dissipation pillars, and the like. In some implementations, the third heat dissipation channels may alternatively be set to be greater than or equal to the second heat dissipation channels, but more complex structures and arrangement manners of the third heat dissipation pillars and the second heat dissipation pillars need to be designed, so that the flow rate in the third heat dissipation device is less than the flow rate in the second heat dissipation device. In this implementation, to simplify a process, the volumes of the third heat dissipation channels are set to be less than the volumes of the second heat dissipation channels. In this solution, the third heat dissipation device and the third heat dissipation pillars are disposed in the heat dissipation apparatus, so that a contact area between the cooling medium and the heat dissipation apparatus can be further increased, and cooling performance of the heat dissipation apparatus can be improved. In addition, space volumes in the third heat dissipation device, the second heat dissipation device, and the first heat dissipation device sequentially increase, so that the cooling medium can be properly distributed in the first heat dissipation device, the second heat dissipation device, and the third heat dissipation device. In this way, the first heat dissipation device closest to the power module has best cooling effect, a temperature of the heat dissipation apparatus is distributed in a gradient manner, and heat dissipation effect is better.

In a possible implementation, the heat dissipation apparatus further includes a substrate, the substrate and the top plate are spaced apart, the substrate is located on a side that is of the top plate and that is away from the bottom plate, the side frame surrounds a peripheral side of the substrate, the side frame is sealed with the substrate in the first direction, and the third heat dissipation device is located in space enclosed by the partition plate, the substrate, and a part of the side frame. The substrate forms a part of the third heat dissipation device, and the substrate is connected to the third heat dissipation pillars. This helps prevent the cooling medium from leaking from the top of fins of the third heat dissipation pillars, improves utilization of the cooling medium, and enhances heat dissipation effect.

In a possible implementation, the third heat dissipation pillars and the top plate are of an integrally formed structure. This solution helps improve structural stability of the heat dissipation apparatus.

In a possible implementation, the heat dissipation apparatus is made of a metal material such as copper. In some other implementations, the heat dissipation apparatus may be made of another material with good thermal conductivity and structural strength, such as non-metal.

According to a second aspect, this application provides a power assembly, including a power module and the heat dissipation apparatus according to any implementation of the first aspect. The power module is fastened to a second surface.

According to a third aspect, this application provides a power supply system, including a power supply, an electrical device, and the power assembly according to the second aspect. The power supply is connected to an input end of a power module, the electrical device is connected to an output end of the power module, and the power module is configured to: convert a direct current output by the power supply into an alternating current, and transmit the alternating current to the electrical device.

According to a fourth aspect, this application provides a vehicle, including a vehicle body and the power supply system according to the third aspect. The power supply system is mounted on the vehicle body.

According to a fifth aspect, this application provides a photovoltaic system, including a photovoltaic module and the power assembly according to the second aspect. The photovoltaic module is electrically connected to the power module, and a direct current generated by the photovoltaic module is converted into an alternating current through a power module.

**BRIEF DESCRIPTION OF DRAWINGS**

To describe technical solutions in embodiments of this application more clearly, the following describes accompanying drawings used in embodiments of this application.

FIG. 1 is a diagram of a structure of a power supply system according to an embodiment of this application;
FIG. 2 is a diagram of a structure of a vehicle according to an embodiment of this application;
FIG. 3 is a diagram of a structure of a photovoltaic system according to an embodiment of this application;
FIG. 4 is a diagram of a structure of a power assembly according to an embodiment of this application;
FIG. 5a is a diagram of a structure of a heat dissipation apparatus according to an embodiment of this application;
FIG. 5b is a top view of first heat dissipation pillars in a heat dissipation apparatus according to an embodiment of this application;
FIG. 6 is a top view of first heat dissipation pillars in a heat dissipation apparatus according to another embodiment of this application;
FIG. 7 is a diagram of a structure of a heat dissipation apparatus according to an embodiment of this application;
FIG. 8 is a diagram of a structure of a heat dissipation apparatus according to an embodiment of this application;
FIG. 9 is a diagram of a structure of a heat dissipation apparatus according to an embodiment of this application;
FIG. 10a is a top view of first heat dissipation pillars in a heat dissipation apparatus according to an embodiment of this application;
FIG. 10b is a top view of second heat dissipation pillars in a heat dissipation apparatus according to an embodiment of this application;

FIG. 11 is a top view of first heat dissipation pillars in a heat dissipation apparatus according to another embodiment of this application;

FIG. 12a is a diagram of structures of first heat dissipation pillars in a heat dissipation apparatus according to an embodiment of this application;

FIG. 12b is a diagram of structures of second heat dissipation pillars in a heat dissipation apparatus according to an embodiment of this application;

FIG. 13 is a diagram of structures of first heat dissipation pillars in a heat dissipation apparatus according to another embodiment of this application;

FIG. 14a is a top view of a first heat dissipation device in a heat dissipation apparatus according to an embodiment of this application;

FIG. 14b is a top view of a second heat dissipation device in a heat dissipation apparatus according to an embodiment of this application;

FIG. 15 is a diagram of projections of first heat dissipation pillars and second heat dissipation pillars on a first surface according to an embodiment of this application;

FIG. 16 is a diagram of projections of first heat dissipation pillars and second heat dissipation pillars on a first surface according to an embodiment of this application;

FIG. 17a is a diagram of a structure of a heat dissipation apparatus according to an embodiment of this application;

FIG. 17b is a top view of first heat dissipation pillars in a heat dissipation apparatus according to an embodiment of this application;

FIG. 17c is a top view of second heat dissipation pillars in a heat dissipation apparatus according to an embodiment of this application;

FIG. 17d is a top view of first heat dissipation pillars and second heat dissipation pillars according to an embodiment of this application;

FIG. 17e is a top view of a first heat dissipation device in a heat dissipation apparatus according to an embodiment of this application;

FIG. 17f is a top view of a second heat dissipation device in a heat dissipation apparatus according to an embodiment of this application;

FIG. 18 is a top view of first heat dissipation pillars and second heat dissipation pillars in a heat dissipation apparatus according to an embodiment of this application;

FIG. 19 is a diagram of a structure of a heat dissipation apparatus according to an embodiment of this application;

FIG. 20 is a diagram of a structure of a heat dissipation apparatus according to an embodiment of this application;

FIG. 21 is a diagram of a structure of a heat dissipation apparatus according to an embodiment of this application; and

FIG. 22 is a diagram of a structure of a heat dissipation apparatus according to an embodiment of this application.

## DESCRIPTION OF EMBODIMENTS

The following describes technical solutions in embodiments of this application with reference to accompanying drawings in embodiments of this application. It is clear that the described embodiments are merely a part rather than all of embodiments of this application.

Parallelism: Parallelism defined in embodiments of this application is not limited to absolute parallelism. The definition of parallelism herein may be understood as basic parallelism, and includes non-absolute parallelism caused by factors such as an assembly tolerance, a design tolerance, and impact of structure flatness.

Perpendicular: Perpendicular defined in embodiments of this application is not limited to an absolute perpendicular intersection (an included angle is 90 degrees) relationship, includes a non-absolute perpendicular intersection relationship caused by factors such as an assembly tolerance, a design tolerance, and impact of structure flatness, and allows an error within a small angle range. For example, a relationship within an assembly error range from 80 degrees to 100 degrees may be understood as a perpendicular relationship.

Terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In descriptions of this application, unless otherwise stated, "a plurality of" means two or more than two.

In addition, in this specification, orientation terms such as "up" and "down" are defined relative to orientations of schematically placed structures in the accompanying drawings. It should be understood that these directional terms are relative concepts and are used for relative description and clarification, and may vary accordingly with changes of the orientations of the structures.

For ease of understanding, the following first explains and describes English abbreviations in embodiments of this application.

MOSFET: Metal-Oxide-Semiconductor Field-Effect Transistor, metal-oxide-semiconductor field-effect transistor.

IGBT: Insulated Gate Bipolar Transistor, insulated gate bipolar transistor.

This application provides a heat dissipation apparatus, and the heat dissipation apparatus may be used in a power assembly, to dissipate heat for the power assembly. The heat dissipation apparatus includes a bottom plate, a first heat dissipation device, and a second heat dissipation device, the bottom plate includes a first surface and a second surface that are disposed opposite to each other, the first heat dissipation device and the second heat dissipation device are stacked on the first surface in a thickness direction of the bottom plate, the first heat dissipation device is located between the first surface and the second heat dissipation device, and the second surface is configured to fasten the power module, to dissipate heat for the power module, so that the first heat dissipation device is closer to the power module than the second heat dissipation device. A plurality of first heat dissipation pillars spaced apart are disposed in the first heat dissipation device, a plurality of second heat dissipation pillars spaced apart are disposed in the second heat dissipation device, and the first heat dissipation pillars and the second heat dissipation pillars are configured to: after a cooling medium flows into the first heat dissipation device and the second heat dissipation device, enable a flow rate in first heat dissipation channels between all the first heat dissipation pillars in the first heat dissipation device to be greater than a flow rate in second heat dissipation channels between all the second heat dissipation pillars in the second heat dissipation device, so that a larger flow rate in the first heat dissipation device can take away more heat transmitted by the power module to the bottom plate, thereby improving cooling effect of the heat dissipation apparatus on the power module.

The heat dissipation apparatus provided in this application may be used in the power assembly, and the power assembly including the heat dissipation apparatus in this application may be used in a photovoltaic system and a power supply system of a vehicle.

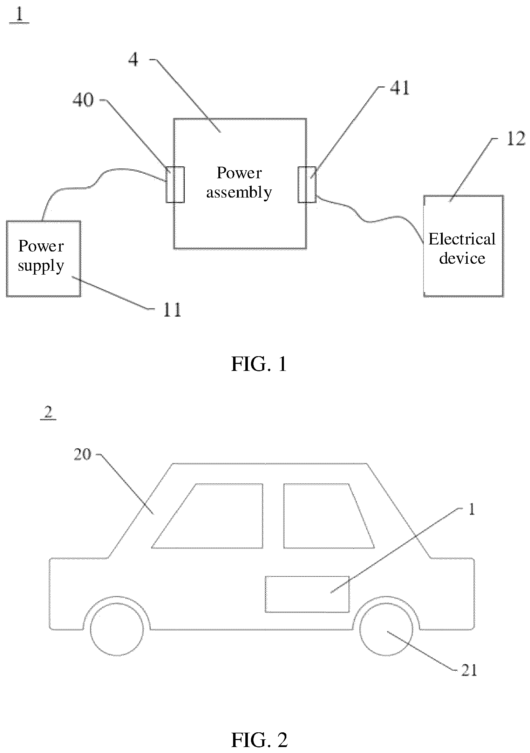

FIG. 1 is a diagram of a structure of a power supply system 1 according to an embodiment of this application. In a possible implementation, the power supply system 1 includes a power assembly 4, a power supply 11, and an electrical device 12, the power supply 11 is connected to an input end 40 of the power assembly 4, the electrical device 12 is connected to an output end 41 of the power assembly 4, and the power assembly 4 is configured to: convert a direct current output by the power supply 11 into an alternating current, and transmit the alternating current to the electrical device 12. The power assembly 4 is a semiconductor apparatus that converts a voltage, a current, a quantity of cycles, and the like of the direct current output by the power supply 11, and is a core apparatus for power conversion of the power supply system 1. For example, the power supply system 1 may be used as a core apparatus for performing direct current-to-alternating current conversion for a motor control unit of an electric vehicle, and convert a direct current into an alternating current required for vehicle running.

FIG. 2 is a diagram of a structure of a vehicle 2 according to an embodiment of this application. In a possible implementation, the vehicle 2 includes a vehicle body 20 and the foregoing power supply system 1, and the power supply system 1 is mounted on the vehicle body 20. The power supply system 1 provides a power source for the vehicle 2. The vehicle 2 includes an electric vehicle/electric vehicle (Electric Vehicle, EV for short), a pure electric vehicle (Pure Electric Vehicle/Battery Electric Vehicle, PEV/BEV for short), a hybrid electric vehicle (Hybrid Electric Vehicle, HEV for short), a range extended electric vehicle (Range Extended Electric Vehicle, REEV for short), a plug-in hybrid vehicle (Plug-in Hybrid Electric Vehicle, PHEV for short), a new energy vehicle (New Energy Vehicle), or the like. In some implementations, the vehicle 2 includes a passenger vehicle and various special operation vehicles with specific functions, for example, an engineering rescue vehicle, a sprinkler, a sewage sucker, a cement mixer, a crane, and a medical vehicle. In this implementation, the vehicle 22 is a vehicle, the power supply 11 is a power battery in the vehicle 2, the electrical device 12 is a motor in the vehicle 2, and the motor can drive wheels 21 to rotate. There may be three or more wheels 21 of the vehicle 2. This is not limited in this application.

In some implementations, the power supply system 1 includes an inverter (not shown in the figure), the power assembly 4 and a control circuit (not shown in the figure) are disposed in the inverter, the control circuit is electrically connected to the power assembly 4, and the control circuit may control, based on a requirement of the vehicle 2, a performance parameter of an alternating current output by the power assembly 4 to the motor, for example, a voltage, a current, a quantity of cycles, or a frequency.

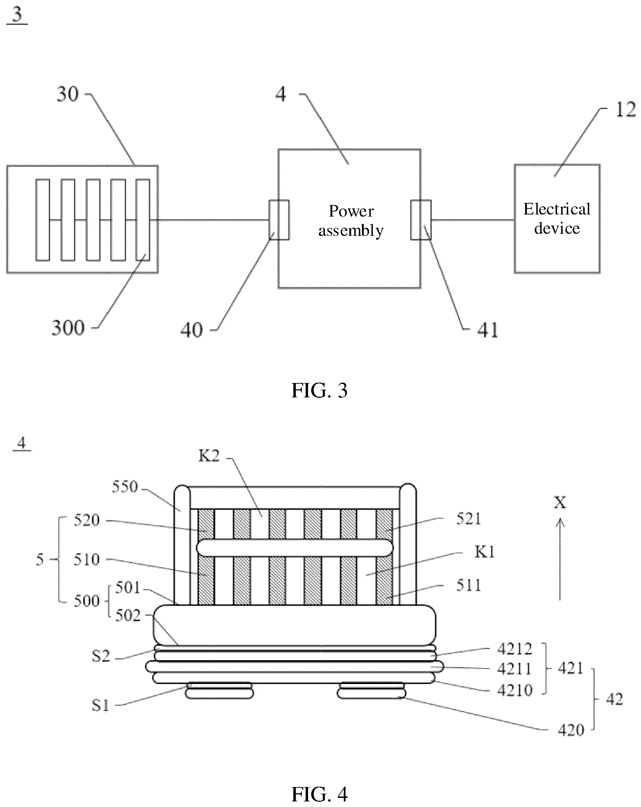

Refer to FIG. 3. The power assembly 4 in this application may be further used in a photovoltaic system 3. FIG. 3 is a diagram of a structure of the photovoltaic system 3 according to an embodiment of this application. In a possible implementation, the photovoltaic system 3 includes a photovoltaic module 30 and the power assembly 4, the photovoltaic module 30 is electrically connected to the power assembly 4, and a direct current generated by the photovoltaic module 30 is converted into an alternating current through the power assembly 4. The alternating current output by the power assembly 4 is transmitted to the electrical device 12, for example, a base station or a data center.

The photovoltaic module 30 includes at least one photovoltaic panel 300, and the photovoltaic panel 300 is connected to the power assembly 4. In an implementation, the photovoltaic module 30 includes a plurality of photovoltaic panels 300 connected in series, and direct currents of the plurality of photovoltaic panels 300 are converged in a series connection manner, and then are connected to the power assembly 4 through a connector. In some implementations, the photovoltaic system 3 includes an inverter (not shown in the figure), the power assembly 4 and a control circuit (not shown in the figure) are disposed in the inverter, the control circuit is electrically connected to the power assembly 4, and the control circuit may control, based on a requirement of the electrical device 12, a performance parameter of the alternating current output by the power assembly 4, for example, a voltage, a current, a quantity of cycles, or a frequency.

FIG. 4 is a diagram of a structure of the power assembly 4 according to an embodiment of this application. In a possible implementation, the power assembly 4 includes a power module 42 and a heat dissipation apparatus 5, and the power module 42 includes power devices 420 and a metal layer-clad substrate 421 that are stacked in a first direction X. The power device 420 is a power electronic device that can implement a power conversion function, and includes but is not limited to a MOSFET, an IGBT, a gate resistor, or a temperature sensor. The metal layer-clad substrate 421 includes an insulating substrate 4211, and a first metal layer 4210 and a second metal layer 4212 that are located on two sides of the insulating substrate 4211, and the first metal layer 4210 and the second metal layer 4212 are insulated through the insulating substrate 4211. The first direction X is a thickness direction of the metal layer-clad substrate 421. In an implementation, the insulating substrate 4211 may be any one of an $Al_2O_3$ ceramic substrate, an AlN ceramic substrate, and a SiN ceramic substrate, and the first metal layer 4210 (for example, copper foil) and the second metal layer 4212 (for example, copper foil) are directly bonded to the insulating substrate 4211 at a high temperature.

In an implementation, the first metal layer 4210 is welded to the power devices 420 through first solder S1, and the second metal layer 4212 is welded to the heat dissipation apparatus 5 through second solder S2. The first solder S1 and the second solder S2 may be selected from at least one of tin solder and lead solder, the tin solder is selected from at least one of SnSb5, SnSb8, SnSbAg, SAC305, SAC multi-component reinforcement, and SnSb10, materials of the first solder S1 and the second solder S2 may be selected based on a requirement, and the first solder S1 and the second solder S2 may be the same or different. SnSb5 is an alloy including 5% by weight of a Sb element in a Sn element. SnSb8 is an alloy including 8% by weight of a Sb element in a Sn element. SnSb10 is an alloy including 10% by weight of a Sb element in a Sn element. SAC in SAC305 represents three metal elements: Sn, Ag, and Cu, and indicates that a product includes three metal components: Sn (tin), Ag (silver), and Cu (copper), where 3 indicates that the product includes 3% Ag, and 05 indicates that the product includes 0.5% Cu. SAC multi-component reinforcement means that other metal components are further included in three metal components Sn (tin), Ag (silver), and Cu (copper), to enhance reliability of solder.

In an implementation, the metal layer-clad substrate 421 may be a direct bond copper (Direct Bond Copper, DBC) ceramic substrate, an active metal brazed copper (Active metal brazed copper, AMB, for example, $Al_2O_3$-AMB, $Si_3N_4$-AMB, or AlN-AMB) substrate, an insulated metal substrate (Insulated metal substrate, IMS), or the like.

The operating power module 42 is frequently switched between a turn-on state and a turn-off state. However, frequent state switching causes the power assembly 4 to generate a large amount of heat, and a high temperature causes a decrease in conversion efficiency of the power module 42 in the power assembly 4 or even causes damage to the power module 42. The power assembly 4 serves as a core component of the power supply system 1, and a decrease in conversion efficiency of the power assembly 4 and damage to the power assembly 4 greatly affect the entire power supply system 1. To reduce a temperature of the operating power assembly 4, the heat dissipation apparatus 5 is usually mounted in the power assembly 4, and a cooling medium flows into the heat dissipation apparatus 5, to exchange heat with the power device 420 that generates heat in the power module 42. However, a problem that different parts in the heat dissipation apparatus 5 in a currently used power assembly 4 have different heat dissipation capabilities is not considered, resulting in poor cooling effect of the heat dissipation apparatus 5 for the power module 42.

In this application, the heat dissipation apparatus 5 is improved, so that flow resistance of the cooling medium on a side that is of the heat dissipation apparatus 5 and that is close to the power module 42 is smaller, thereby helping improve the cooling effect of the heat dissipation apparatus 5.

The following describes the heat dissipation apparatus 5 in this application in detail.

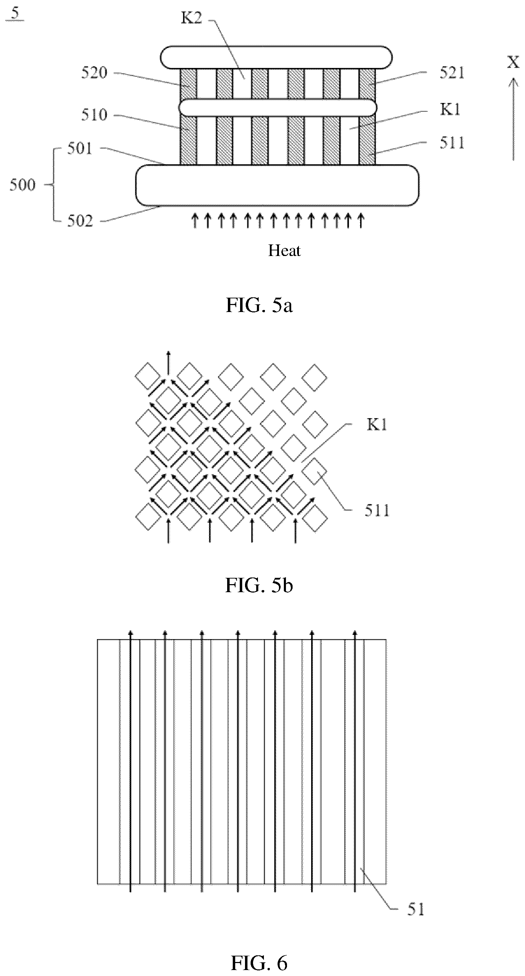

Refer to FIG. 4, FIG. 5a, and FIG. 5b together. FIG. 5a is a diagram of a structure of the heat dissipation apparatus 5 according to an embodiment of this application, and FIG. 5b is a top view of first heat dissipation pillars 511 in the heat dissipation apparatus 5 according to an embodiment of this application. This application provides the heat dissipation apparatus 5. The heat dissipation apparatus 5 includes a bottom plate 500, a first heat dissipation device 510, and a second heat dissipation device 520 (as shown in FIG. 5a). The bottom plate 500 includes a first surface 501 and a second surface 502 that are disposed opposite to each other (as shown in FIG. 5a). The first heat dissipation device 510 and the second heat dissipation device 520 are stacked on the first surface 501 in a thickness direction X of the bottom plate 500 (as shown in FIG. 5a), and the first heat dissipation device 510 is located between the first surface 501 and the second heat dissipation device 520 (as shown in FIG. 5a). The second surface 502 is used to fasten the power module 42 (as shown in FIG. 4), to dissipate heat for the power module 42.

A plurality of first heat dissipation pillars 511 spaced apart are disposed in the first heat dissipation device 510 (as shown in FIG. 5a and FIG. 5b), and a plurality of second heat dissipation pillars 521 spaced apart are disposed in the second heat dissipation device 520 (as shown in FIG. 5a). After a cooling medium flows into the first heat dissipation device 510 and the second heat dissipation device 520, a flow rate in first heat dissipation channels K1 between all the first heat dissipation pillars 511 in the first heat dissipation device 510 is greater than a flow rate in second heat dissipation channels K2 between all the second heat dissipation pillars 521 in the second heat dissipation device 520.

One of functions of the bottom plate 500 is to fasten the first heat dissipation device 510 and the second heat dissipation device 520. To be specific, the first surface 501 of the bottom plate 500 is connected to the first heat dissipation device 510 (as shown in FIG. 4), the bottom plate 500, the first heat dissipation device 510, and the second heat dissipation device 520 are stacked in the thickness direction X of the bottom plate 500, and the thickness direction X of the bottom plate 500 is defined as a first direction X. Another function of the bottom plate 500 is to transfer heat from the power module 42 to the heat dissipation apparatus 5. To be specific, the second surface 502 of the bottom plate 500 is fastened to the power module 42 (as shown in FIG. 4), and heat generated by the power device 420 in the power module 42 is transferred to the second surface 502 of the bottom plate 500 through the metal layer-clad substrate 421, and then is in contact with the first heat dissipation device 510 and the second heat dissipation device 520 through the first surface 501 of the bottom plate 500. In an implementation, the second surface 502 of the bottom plate 500 is welded to the power module 42 through solder, and the bottom plate 500 is made of a thermally conductive material. This helps reduce thermal resistance of the heat dissipation apparatus 5.

The first heat dissipation device 510 and the second heat dissipation device 520 are configured to: connect to a cooling system (not shown in the figure), and transmit a cooling medium provided by the cooling system. When heat is transferred from the power module 42 to the heat dissipation apparatus 5, the cooling medium in the first heat dissipation device 510 and the second heat dissipation device 520 exchanges heat with the power module 42, and the heat dissipation apparatus 5 takes the heat away from the power module 42, to reduce a temperature of the power device 420 in a steady working state, and control a temperature of the power module 42. In this implementation, the cooling medium is non-conductive pure water. In some other implementations, the cooling medium may be any one of fluoride, methyl silicone oil, silicone oil, and mineral oil. A person skilled in the art may select a type of the cooling medium based on an actual requirement. This is not limited in this application.

In this implementation, the plurality of first heat dissipation pillars 511 are spaced apart in the first heat dissipation device 510, and the plurality of second heat dissipation pillars 521 are spaced apart in the second heat dissipation device 520. In this way, the first heat dissipation pillars 511 and the second heat dissipation pillars 521 can increase a contact area between the heat dissipation apparatus 5 and the cooling medium, to enhance turbulence of the cooling medium, and improve a surface heat transfer coefficient.

In addition, refer to FIG. 5b and FIG. 6 together. FIG. 6 is a top view of first heat dissipation pillars 511 in a heat dissipation apparatus 5 according to another embodiment of this application. In the heat dissipation apparatus 5 shown in FIG. 6, heat dissipation channels are through holes 51 extending in one direction, and two adjacent through holes 51 are not connected to each other. If a solution in which a plurality of through holes 51 are disposed in the heat dissipation apparatus 5 (as shown in FIG. 6) is used, flow channels of a cooling medium in the heat dissipation apparatus 5 are isolated by the through holes and are independent of each other. Consequently, heat exchange effect is limited. However, in this application, the first heat dissipation pillars 511 divide the first heat dissipation device 510 into the first heat dissipation channels K1 that are connected to each other (as shown in FIG. 5b), the second heat dissipation pillars 521 divide the second heat dissipation device 520 into the second heat dissipation channels K2 that are connected to each other, and gaps between the first heat dissipation pillars 511 and gaps between the second heat dissipation pillars 521 form heat dissipation channels. When the cooling medium flows into the gaps between the first heat dissipation pillars 511, the cooling medium may flow into a gap between any two adjacent first heat dissipation pillars 511, and when the cooling medium flows into the gaps between the second heat dissipation pillars 521, the cooling medium may flow into a gap between any two adjacent second heat dissipation pillars 521. In this way, flow channels of the cooling medium in the heat dissipation apparatus 5 are connected to each other. This helps reduce flow resistance of the cooling medium, and improves heat dissipation efficiency.

In this implementation, because the first heat dissipation device 510 is connected to the first surface 501 of the bottom plate 500, and the second surface 502 of the bottom plate 500 is connected to the power module 42, the first heat dissipation device 510 is closer to the power module 42 than the second heat dissipation device 520. In addition, because the operating power module 42 generates a large amount of heat, a temperature of the first heat dissipation device 510 closer to the power module 42 is higher than a temperature of the second heat dissipation device 520.

If only one heat dissipation device is disposed in the heat dissipation apparatus 5, a side that is of the heat dissipation device and that is close to the power module 42 has a high temperature and large thermal resistance. Alternatively, if two or more heat dissipation devices with a same space volume are stacked in the heat dissipation apparatus 5, a heat dissipation condition of a heat dissipation device close to the power module 42 is poor due to local overheating, and overall cooling efficiency of the heat dissipation apparatus 5 is also affected.

In this implementation, the flow rate in the first heat dissipation channels K1 between all the first heat dissipation pillars 511 in the first heat dissipation device 510 is set to be greater than the flow rate in the second heat dissipation channels K2 between all the second heat dissipation pillars 521 in the second heat dissipation device 520, and flow resistance of the cooling medium is small, so that cooling effect of the first heat dissipation device 510 is stronger, and the first heat dissipation device 510 is cooperated with the second heat dissipation device 520. This helps the heat dissipation apparatus 5 conduct heat, and improves overall heat dissipation effect of the heat dissipation apparatus 5. The first heat dissipation channels K1 between all the first heat dissipation pillars 511 are a sum of the gaps between all the first heat dissipation pillars 511, and the second heat dissipation channels K2 between all the second heat dissipation pillars 521 are a sum of the gaps between all the second heat dissipation pillars 521.

In this application, the heat dissipation apparatus 5 is disposed in the power assembly 4. First, the first heat dissipation pillars 511 and the second heat dissipation pillars 521 increase a contact area between the cooling medium and the first heat dissipation device 510 and a contact area between the cooling medium and the second heat dissipation device 520, thereby helping improve heat exchange efficiency.

Second, the first heat dissipation pillars 511 divide the first heat dissipation device 510 into mutually connected flow channels, and the second heat dissipation pillars 521 divide the second heat dissipation device 520 into mutually connected flow channels, so that flow resistance of the cooling medium in the first heat dissipation device 510 and the second heat dissipation device 520 is small.

Third, the first heat dissipation pillars 511 and the second heat dissipation pillars 521 are configured to: after the cooling medium flows into the first heat dissipation device 510 and the second heat dissipation device 520, enable a flow rate in the first heat dissipation device 510 to be greater than a flow rate in the second heat dissipation device 520, so that a larger flow rate in the first heat dissipation device 510 can take away more heat transmitted by the power module 42 to the bottom plate 500, thereby improving cooling effect of the heat dissipation apparatus on the power module 42. The flow rate in the first heat dissipation channels K1 between all the first heat dissipation pillars 511 in the first heat dissipation device 510 is set to be greater than the flow rate in the second heat dissipation channels K2 between all the second heat dissipation pillars 521 in the second heat dissipation device 520, so that a flow velocity and the flow rate of the cooling medium are larger in the first heat dissipation device 510. In this way, a heat dissipation capability of the heat dissipation apparatus 5 on a side adjacent to the power module is improved, thereby helping improve the cooling effect of the heat dissipation apparatus 5 on the power module 42.

In a possible implementation, fluid resistance of all the first heat dissipation pillars 511 in the first heat dissipation device 510 is less than fluid resistance of all the second heat dissipation pillars 521 in the second heat dissipation device 520. Fluid resistance is resistance endured by an object from a fluid when the object moves relative to the fluid in the fluid (a liquid or a gas). In this implementation, fluid resistance of the first heat dissipation pillar 511 is resistance endured by the first heat dissipation pillar 511 from the cooling medium when the first heat dissipation pillar 511 moves relative to the cooling medium in the cooling medium; and fluid resistance of the second heat dissipation pillar 521 is resistance endured by the second heat dissipation pillar 521 from the cooling medium when the second heat dissipation pillar 521 moves relative to the cooling medium in the cooling medium.

The first heat dissipation pillars 511 are used as an example. A calculation formula of the fluid resistance F of all the first heat dissipation pillars 511 is as follows:

$$F = \sum_{i,j=1}^{N} F_{ij}$$

$$F_{ij} = \int_{S_C, i, j} (pI - \tau) dS_C.$$

i and j are index numbers of each first heat dissipation pillar 511 in two vertical directions, N is a total quantity of first heat dissipation pillars 511, $F_{ij}$ is fluid resistance to a first heat dissipation pillar 511 with index numbers (i, j), $S_C$ is a surface area in which one first heat dissipation pillar 511 is in contact with the cooling medium, p is a pressure applied to each first heat dissipation pillar 511, I is an identity matrix, pI is a pressure tensor, and $\tau$ is shear force applied to a wall surface of the first heat dissipation device 510.

In this implementation, shapes of the first heat dissipation pillar 511 and the second heat dissipation pillar 521 are set, so that the fluid resistance of the first heat dissipation pillar 511 is less than the fluid resistance of the second heat dissipation pillar 521.

Still refer to FIG. 5a. In a possible implementation, a sum V1 of volumes of the first heat dissipation channels K1 between all the first heat dissipation pillars 511 is greater than a sum V2 of volumes of the second heat dissipation channels K2 between all the second heat dissipation pillars 521.

In this implementation, the sum of the volumes of the first heat dissipation channels K1 between all the first heat dissipation pillars 511 in the first heat dissipation device 510 is V1, the sum of the volumes of the second heat dissipation channels K2 between all the second heat dissipation pillars 521 in the second heat dissipation device 520 is V2, and the first heat dissipation channels K1 and the second heat dissipation channels K2 are configured to allow the cooling medium to circulate. V1>V2 is set, so that after the cooling medium flows into the first heat dissipation device 510 and the second heat dissipation device 520, the flow rate in the first heat dissipation device 510 is greater than the flow rate in the second heat dissipation device 520. In some implementations, V1 may alternatively be set to be less than or equal to V2, but more complex structures and arrangement manners of the first heat dissipation pillars 511 and the second heat dissipation pillars 521 need to be designed, so that the flow rate in the first heat dissipation device 510 is greater than the flow rate in the second heat dissipation device 520. In this implementation, to simplify a process, the sum V1 of the volumes of the first heat dissipation channels K1 is set to be greater than the sum V2 of the volumes of the second heat dissipation channels K2.

In this implementation, the sum V1 of the volumes of the first heat dissipation channels K1 is set to be greater than the sum V2 of the volumes of the second heat dissipation channels K2. Because the first heat dissipation channels K1 are larger, the cooling medium has smaller flow resistance and a larger flow rate in the first heat dissipation channels K1, so that the first heat dissipation device 510 has stronger cooling effect, and the first heat dissipation device 510 is cooperated with the second heat dissipation device 520. This helps the heat dissipation apparatus 5 conduct heat, and improves overall heat dissipation effect of the heat dissipation apparatus 5.

When the sum V1 of the volumes of the first heat dissipation channels K1 in the first heat dissipation device 510 is measured, liquid (for example, the cooling medium) may be first filled in the first heat dissipation device 510, and then a volume of the liquid in the first heat dissipation device 510 is measured, to obtain the sum V1 of the volumes of the first heat dissipation channels K1. For measurement of the sum V2 of the volumes of the second heat dissipation channels K2 in the second heat dissipation device 520, refer to the foregoing method. Alternatively, the volumes may be measured by using a filling method. To be specific, a medium is filled in the first heat dissipation channels K1, and a volume of the medium is measured after the first heat dissipation channels K1 is filled with the medium. It may be understood that V1 and V2 may alternatively be measured by using another method.

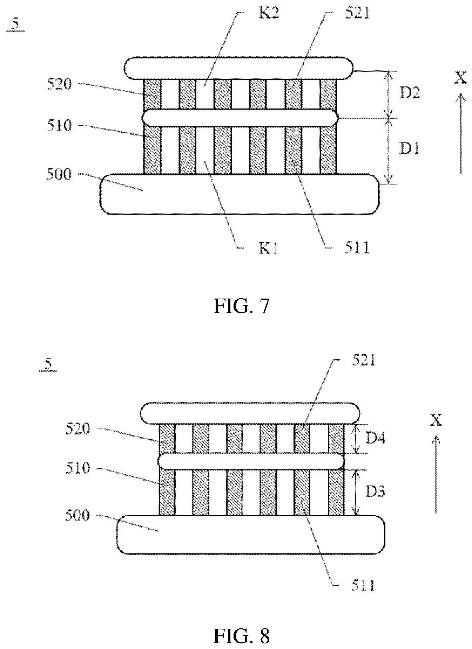

FIG. 7 is a diagram of a structure of the heat dissipation apparatus 5 according to an embodiment of this application. In a possible implementation, the first heat dissipation device 510 includes a plurality of first heat dissipation pillars 511 located at an edge, and the second heat dissipation device 520 includes a plurality of second heat dissipation pillars 521 located at an edge; the plurality of first heat dissipation pillars 511 located at the edge of the first heat dissipation device 510 one-to-one correspond to the plurality of second heat dissipation pillars 521 located at the edge of the second heat dissipation device 520, and each first heat dissipation pillar 511 is at least partially aligned with a corresponding second heat dissipation pillar 521; and a length of the first heat dissipation device 510 in the thickness direction X of the bottom plate 500 is greater than a length of the second heat dissipation device 520 in the thickness direction X of the bottom plate 500.

In this implementation, an area enclosed by first heat dissipation pillars 511 located at an outermost edge of the first heat dissipation device 510 is equal to an area enclosed by second heat dissipation pillars 521 located at an outermost edge of the second heat dissipation device 520, the length of the first heat dissipation device 510 in the first direction X is D1, the length of the second heat dissipation device 520 in the first direction X is D2, and D1>D2 is set, so that the sum V1 of the volumes of the first heat dissipation channels K1 between all the first heat dissipation pillars 511 in the first heat dissipation device 510 can be greater than the sum V2 of the volumes of the second heat dissipation channels K2 between all the second heat dissipation pillars 521 in the second heat dissipation device 520. In this way, the flow rate and a flow velocity of the cooling medium in the first heat dissipation device 510 are greater than the flow rate and a flow velocity of the cooling medium in the second heat dissipation device 520. This helps improve cooling effect of the first heat dissipation device 510, and improves a temperature distribution status of the heat dissipation apparatus 5.

In an implementation, the first heat dissipation pillar 511 and the second heat dissipation pillar 521 have a same cross-sectional area, and a quantity of first heat dissipation pillars 511 is the same as a quantity of second heat dissipation pillars 521. In this case, the volumes V1 of the first heat dissipation channels K1 between all the first heat dissipation pillars 511 in the first heat dissipation device 510 can be greater than the volumes V2 of the second heat dissipation channels K2 between all the second heat dissipation pillars 521 in the second heat dissipation device 520 only by setting the length of the first heat dissipation device 510 in the first direction X to be greater than the length of the second heat dissipation device 520 in the first direction X.

In some embodiments, a length of the first heat dissipation pillar 511 in the first direction X may be greater than, equal to, or less than a length of the second heat dissipation pillar 521 in the first direction X.

FIG. 8 is a diagram of a structure of the heat dissipation apparatus 5 according to an embodiment of this application. In a possible implementation, the length of the first heat dissipation pillar 511 in the thickness direction X of the bottom plate 500 is greater than the length of the second heat dissipation pillar 521 in the thickness direction X of the bottom plate 500.

In this implementation, the length of the first heat dissipation pillar 511 in the first direction X is greater than the length of the second heat dissipation pillar 521 in the first direction X, and both a cross section of the first heat dissipation device 510 and a cross section of the second heat dissipation device 520 are perpendicular to the first direction X. In this implementation, the length of the first heat dissipation pillar 511 in the first direction X is D3, the length of the second heat dissipation pillar 521 in the first direction X is D4, and D3>D4. It may be understood that, when the cooling medium flows into the first heat dissipation device 510, both an inner wall of the first heat dissipation device 510 and outer surfaces of the first heat dissipation pillars 511 are in contact with the cooling medium. Therefore, a larger length of the first heat dissipation pillar 511 in the first direction X indicates a larger contact area between the first heat dissipation pillar 511 and the cooling medium and better flow disturbing effect of the first heat dissipation pillar 511 on the cooling medium. This helps improve cooling effect of the first heat dissipation device 510.

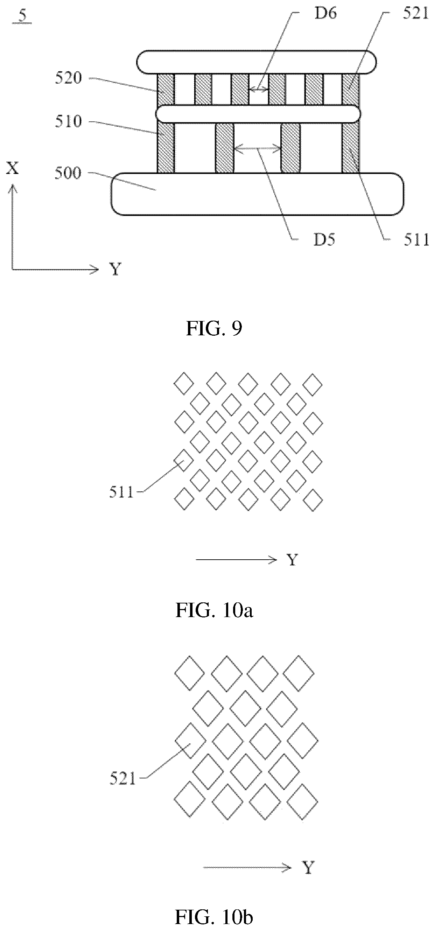

FIG. 9 is a diagram of a structure of the heat dissipation apparatus 5 according to an embodiment of this application. In a possible implementation, a spacing between every two first heat dissipation pillars 511 in the first heat dissipation device 510 is greater than a spacing between every two second heat dissipation pillars 521 in the second heat dissipation device 520 (as shown in FIG. 9). In this implementation, a second direction Y is parallel to the first surface 501 of the bottom plate 500 (as shown in FIG. 9), and perpendicularly intersects the first direction X.

The spacing between every two first heat dissipation pillars 511 in the first heat dissipation device 510 may be a spacing in the second direction, or may be a spacing in any direction parallel to the first surface 501.

In this implementation, the spacing between every two first heat dissipation pillars 511 is a spacing between the two first heat dissipation pillars 511 in the second direction, and a value of the spacing is denoted as D5; and the spacing between every two second heat dissipation pillars 521 is a spacing between the two second heat dissipation pillars 521 in the second direction, and a value of the spacing is denoted as D6. D5>D6 is set, so that the volumes V1 of the first heat dissipation channels K1 between all the first heat dissipation pillars 511 in the first heat dissipation device 510 are greater than the volumes V2 of the second heat dissipation channels K2 between all the second heat dissipation pillars 521 in the second heat dissipation device 520. In this way, flow resistance of the cooling medium between every two first heat dissipation pillars 511 is less than flow resistance of the cooling medium between every two second heat dissipation pillars 521. This helps increase a flow velocity of the cooling medium in the first heat dissipation device 510. In addition, a higher flow velocity of the cooling medium indicates better heat exchange effect, thereby properly distributing the cooling medium in the first heat dissipation device 510 and the second heat dissipation device 520.

In this implementation, a length of the first heat dissipation device 510 in the second direction is the same as a length of the second heat dissipation device 520 in the second direction. In this case, distribution density of the first heat dissipation pillars 511 in the first heat dissipation device 510 is less than distribution density of the second heat dissipation pillars 521 in the second heat dissipation device 520, and a smaller space volume occupied by the first heat dissipation pillars 511 in the first heat dissipation device 510 indicates larger volumes of the first heat dissipation channels K1 through which the cooling medium flows. Therefore, flow resistance of the first heat dissipation device 510 is smaller, and cooling effect of the first heat dissipation device 510 is improved.

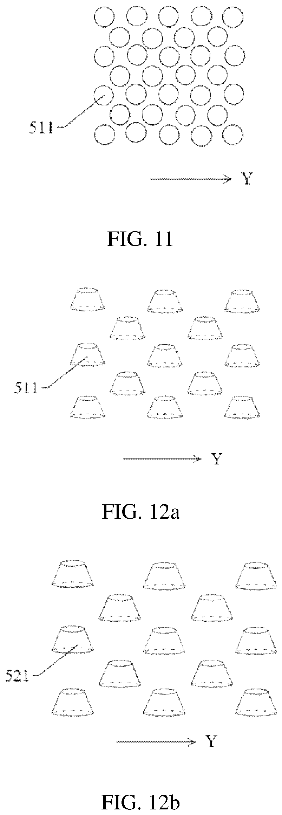

Refer to FIG. 10a, FIG. 10b, and FIG. 11. FIG. 10a is a top view of the first heat dissipation pillars 511 in the heat dissipation apparatus 5 according to an embodiment of this application, FIG. 10b is a top view of the second heat dissipation pillars 521 in the heat dissipation apparatus 5 according to an embodiment of this application, and FIG. 11 is a top view of the first heat dissipation pillars 511 in the heat dissipation apparatus 5 according to another embodiment of this application. In a possible implementation, an area of a cross section of the first heat dissipation pillar 511 is less than an area of a cross section of the second heat dissipation pillar 521 (as shown in FIG. 10a and FIG. 10b), and both the cross section of the first heat dissipation pillar 511 and the cross section of the second heat dissipation pillar 521 are perpendicular to the thickness direction X of the bottom plate 500.

Both the cross section of the first heat dissipation pillar 511 and the cross section of the second heat dissipation pillar 521 are parallel to the second direction and the first surface 501 of the bottom plate 500. Two end faces of the first heat dissipation pillar 511 in the first direction X have a same shape and a same area, and two end faces of the second heat dissipation pillar 521 in the first direction X have a same shape and a same area. For example, the first heat dissipation pillar 511 and the second heat dissipation pillar 521 are square pillars (as shown in FIG. 10a and FIG. 10b) or cylinders (as shown in FIG. 11). It should be noted that a same shape and a same area herein are not limited to being absolutely the same, and may be understood as being basically the same, and a case in which shapes and areas are not absolutely the same due to factors such as an assembly tolerance, a design tolerance, and structural flatness is allowed.

In this implementation, when an area of a cross section of the first heat dissipation device 510 is equal to an area of a cross section of the second heat dissipation device 520, the area of the cross section of the first heat dissipation pillar 511 is set to be less than the area of the cross section of the second heat dissipation pillar 521, so that a spacing between every two first heat dissipation pillars 511 is larger, and the volumes of the first heat dissipation channels K1 through which the cooling medium flows are larger. This helps reduce flow resistance of the cooling medium in the first heat dissipation device 510. When the area of the cross section of the first heat dissipation device 510 is not equal to the area of the cross section of the second heat dissipation device 520, the area of the cross section of the first heat dissipation pillar 511 is set to be less than the area of the cross section of the second heat dissipation pillar 521, so that a flow volume of the cooling medium in the first heat dissipation device 510 is larger.

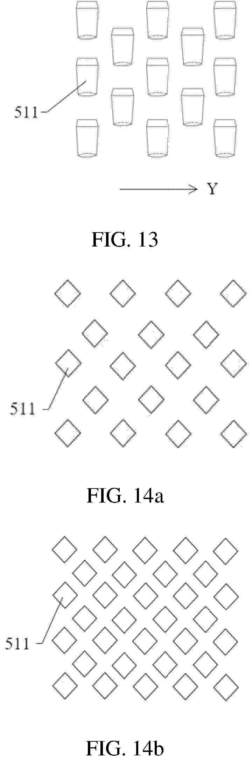

Refer to FIG. 12a to FIG. 13. FIG. 12a is a diagram of structures of the first heat dissipation pillars 511 in the heat dissipation apparatus 5 according to an embodiment of this application, FIG. 12b is a diagram of structures of the second heat dissipation pillars 521 in the heat dissipation apparatus 5 according to an embodiment of this application, and FIG. 13 is a diagram of structures of the first heat dissipation pillars 511 in the heat dissipation apparatus 5 according to another embodiment of this application. In a possible implementation, a volume of the first heat dissipation pillar 511 is less than a volume of the second heat dissipation pillar 521 (as shown in FIG. 12a and FIG. 12b).

In this implementation, two end faces of the first heat dissipation pillar 511 in the first direction X are different, and two end faces of the second heat dissipation pillar 521 in the first direction X are different. Specifically, there may be the following three cases, and the first heat dissipation pillar 511 is used as an example for description. In a first case, the two end faces of the first heat dissipation pillar 511 in the first direction X have a same shape but different areas. For example, the first heat dissipation pillar 511 is a cylindrical table pillar (as shown in FIG. 12a). In a second case, the two end faces of the first heat dissipation pillar 511 in the first direction X have different shapes but a same area. For example, the first heat dissipation pillar 511 is chopstick-shaped (as shown in FIG. 13). In a third case, the two end faces of the first heat dissipation pillar 511 in the first direction X have different shapes and different areas. For example, the first heat dissipation pillar 511 is a conical pillar, a triangular pillar, an olive shape, an ellipsoid shape, an hourglass shape, a dumbbell shape, a water droplet shape, or an irregular shape.

In this implementation, the volume of the first heat dissipation pillar 511 is set to be less than the volume of the second heat dissipation pillar 521, so that the volumes of the first heat dissipation channels K1 through which the cooling medium flows in the first heat dissipation device 510 are greater than the volumes of the second heat dissipation channels K2 through which the cooling medium flows in the second heat dissipation device 520, thereby effectively improving cooling efficiency of the cooling medium in the first heat dissipation device 510.

Refer to FIG. 14a and FIG. 14b. FIG. 14a is a top view of the first heat dissipation device 510 in the heat dissipation apparatus 5 according to an embodiment of this application, and FIG. 14b is a top view of the second heat dissipation device 520 in the heat dissipation apparatus 5 according to an embodiment of this application. In a possible implementation, a quantity of first heat dissipation pillars 511 is less than a quantity of second heat dissipation pillars 521. In this implementation, when the first heat dissipation pillar 511 and the second heat dissipation pillar 521 have a same shape, and a total volume of internal space of the first heat dissipation device 510 is equal to a total volume of internal space of the second heat dissipation device 520, the quantity of first heat dissipation pillars 511 is set to be less than the quantity of second heat dissipation pillars 521, so that distribution density of the first heat dissipation pillars 511 in the first heat dissipation device 510 is less than distribution density of the second heat dissipation pillars 521 in the second heat dissipation device 520. When the cooling medium separately flows into the first heat dissipation device 510 and the second heat dissipation device 520, the cooling medium encounters less blockage from the first heat dissipation pillars 511 and fewer collisions between the first heat dissipation pillars 511 and the cooling medium, so that the cooling medium flows more smoothly in the first heat dissipation device 510. This helps the cooling medium fully utilize heat dissipation effect.

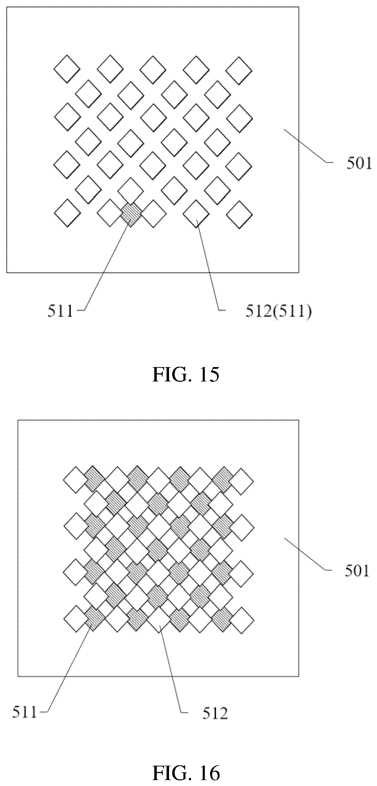

FIG. 15 is a diagram of projections of the first heat dissipation pillars 511 and the second heat dissipation pillars 521 on the first surface 501 according to an embodiment of this application. In a possible implementation, an orthographic projection of at least one of the plurality of first heat dissipation pillars 511 on the first surface 501 and an orthographic projection of at least one of the plurality of second heat dissipation pillars 521 on the first surface 501 are staggered.

In this implementation, space in which the cooling medium exchanges heat is the first heat dissipation channels K1 between all the first heat dissipation pillars 511 in the first heat dissipation device 510 and the second heat dissipation channels K2 between all the second heat dissipation pillars 521 in the second heat dissipation device 520, and the first heat dissipation pillars 511 and the second heat dissipation pillars 521 have a higher heat conduction capability than the cooling medium. In this application, an orthographic projection of at least one first heat dissipation pillar 511 on the first surface 501 and an orthographic projection of at least one second heat dissipation pillar 521 on the first surface 501 are set to be staggered, and the gaps between the first heat dissipation pillars 511 partially overlap the second heat dissipation pillars 521, so that heat of the cooling medium in the gaps between the first heat dissipation pillars 511 (or the first heat dissipation channels K1) can be transmitted upward to the second heat dissipation pillars 521. In this way, the second heat dissipation device 520 can assist the first heat dissipation device 510 in cooling, thereby improving cooling efficiency of the first heat dissipation device 510. Staggering means non-overlapping or incomplete overlapping.

FIG. 16 is a diagram of projections of the first heat dissipation pillars 511 and the second heat dissipation pillars 521 on the first surface 501 according to an embodiment of this application. In an implementation, an orthographic projection of each of the plurality of first heat dissipation pillars 511 on the first surface 501 and an orthographic projection of each of the plurality of second heat dissipation pillars 521 on the first surface 501 are staggered. This solution helps further improve heat conduction effect.

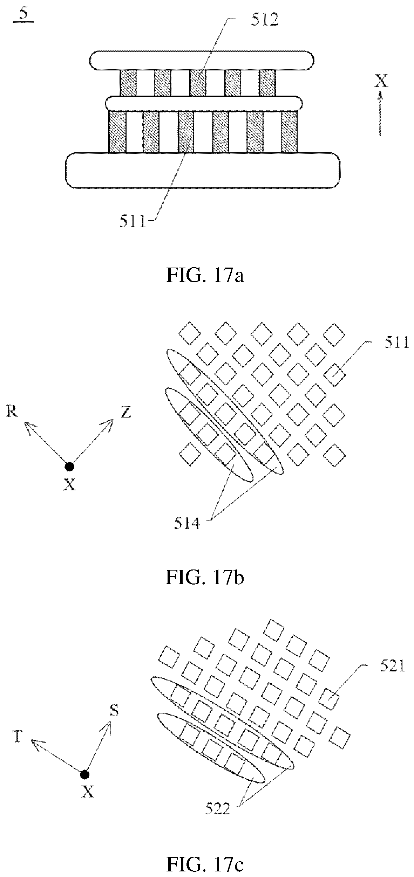

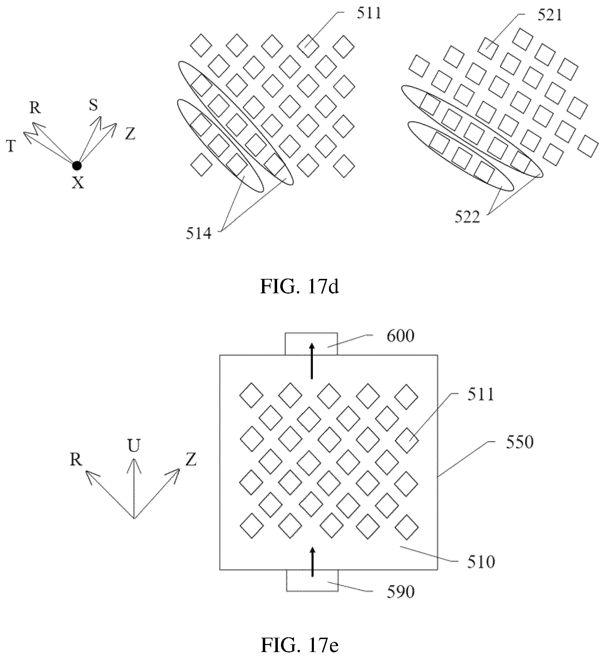

Refer to FIG. 17a to FIG. 17d. FIG. 17a is a diagram of a structure of the heat dissipation apparatus 5 according to an embodiment of this application, FIG. 17b is a top view of the first heat dissipation pillars 511 in the heat dissipation apparatus 5 according to an embodiment of this application, FIG. 17c is a top view of the second heat dissipation pillars 521 in the heat dissipation apparatus 5 according to an embodiment of this application, and FIG. 17d is a top view of the first heat dissipation pillars 511 and the second heat dissipation pillars 521 according to an embodiment of this application. The top views are perpendicular to the first direction X.

In a possible implementation, the plurality of first heat dissipation pillars 511 and the plurality of second heat dissipation pillars 521 are regularly arranged, and at least one first heat dissipation pillar 511 and one second heat dissipation pillar 521 are staggered. When the plurality of first heat dissipation pillars 511 and the plurality of second heat dissipation pillars 521 are regularly arranged, and the at least one first heat dissipation pillar and one second heat dissipation pillar are staggered, it indicates that an arrangement rule of the plurality of first heat dissipation pillars 511 and an arrangement rule of the plurality of second heat dissipation pillars 521 are different. In this way, the cooling medium in the first heat dissipation channels K1 can transfer heat to the second heat dissipation pillars 521 located above the first heat dissipation channels K1, and the second heat dissipation pillars 521 directly absorb the heat in the first direction X. This shortens a heat transfer path, and helps improve efficiency of heat exchange between the cooling medium in the first heat dissipation channels K1 and the cooling medium in the second heat dissipation channels K2.

In this implementation, for example, that the plurality of first heat dissipation pillars 511 are regularly arranged means that the plurality of first heat dissipation pillars 511 include a plurality of groups of first heat dissipation pillars 514 arranged in a third direction Z (as shown in FIG. 17b), each group of first heat dissipation pillars 514 includes a plurality of first heat dissipation pillars 511 arranged at intervals in a fourth direction R (as shown in FIG. 17b), the third direction Z intersects the fourth direction R, and both the third direction Z and the fourth direction R intersect the first direction X (as shown in FIG. 17b).

In this implementation, for example, that the plurality of second heat dissipation pillars 521 are regularly arranged means that the plurality of second heat dissipation pillars 521 include a plurality of groups of second heat dissipation pillars 522 arranged in a fifth direction S (as shown in FIG. 17c), each group of second heat dissipation pillars 522 includes a plurality of second heat dissipation pillars 521 arranged at intervals in a sixth direction T (as shown in FIG. 17c), the fifth direction S intersects the sixth direction T, and both the fifth direction S and the sixth direction T intersect the first direction X (as shown in FIG. 17c). In some other embodiments, the plurality of first heat dissipation pillars 511 and the plurality of second heat dissipation pillars 521 may alternatively be arranged according to another rule. For example, the plurality of first heat dissipation pillars 511 and the plurality of second heat dissipation pillars 521 may be distributed in a radial shape or a concentric circle, provided that it is ensured that the orthographic projection of at least one of the first heat dissipation pillars 511 on the first surface 501 and the orthographic projection of at least one of the second heat dissipation pillars 521 on the first surface 501 are staggered.

The third direction Z intersects the fifth direction S, and the fourth direction R intersects the sixth direction T (as shown in FIG. 17d).

In this implementation, because the first heat dissipation device 510, the second heat dissipation device 520, and the bottom plate 500 are stacked, the third direction Z, the fourth direction R, the fifth direction S, and the sixth direction T are all parallel to the first surface 501 of the bottom plate 500. In this solution, the third direction Z is set to intersect the fifth direction S, and the fourth direction R is set to intersect the sixth direction T, so that the first heat dissipation pillars 511 and the second heat dissipation pillars 521 are arranged in different manners, and the orthographic projection of the first heat dissipation pillar 511 on the first surface 501 and the orthographic projection of the second heat dissipation pillar 521 on the first surface 501 are staggered, thereby improving cooling efficiency of the second heat dissipation device 520 and the first heat dissipation device 510.

In an implementation, as shown in FIG. 17b, a quantity of first heat dissipation pillars 511 in a group of first heat dissipation pillars 514 first increases and then decreases in the third direction Z, so that all the first heat dissipation pillars 511 form a square as a whole. Similarly, a quantity of second heat dissipation pillars 521 in a group of second heat dissipation pillars 522 first increases and then decreases in the third direction Z, so that all the second heat dissipation pillars 521 form a square as a whole.

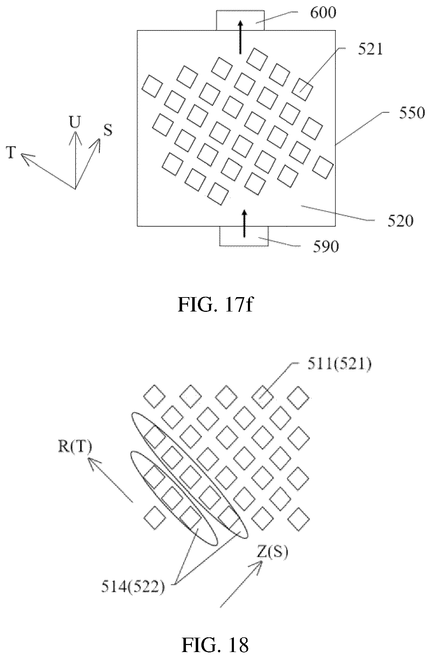

Refer to FIG. 17e and FIG. 17f. FIG. 17e is a top view of the first heat dissipation device 510 in the heat dissipation apparatus 5 according to an embodiment of this application, and FIG. 17f is a top view of the second heat dissipation device 520 in the heat dissipation apparatus 5 according to an embodiment of this application. In an implementation, the heat dissipation apparatus 5 further includes a liquid inlet 590 and a liquid outlet 600, the liquid inlet 590 and the liquid outlet 600 are respectively located on two sides of the first heat dissipation device 510 and the second heat dissipation device 520 in a seventh direction U (as shown in FIG. 17e and FIG. 17f), and the seventh direction U intersects the third direction Z, the fourth direction R, the fifth direction S, and the sixth direction T (as shown in FIG. 17e and FIG. 17f), so that a degree of mixing of the cooling medium is higher after the cooling medium enters the first heat dissipation device 510 and the second heat dissipation device 520, thereby improving heat dissipation effect.

FIG. 18 is a top view of the first heat dissipation pillars 511 and the second heat dissipation pillars 521 in the heat dissipation apparatus 5 according to an embodiment of this application. In some implementations, the first heat dissipation pillars 511 and the second heat dissipation pillars 521 are arranged in a same manner, and a group of first heat dissipation pillars 514 and a group of second heat dissipation pillars 522 are arranged in a same manner, that is, the third direction Z is the same as the fifth direction S, and the fourth direction R is the same as the sixth direction T. This solution helps reduce processing difficulty and manufacturing costs of the heat dissipation apparatus 5.

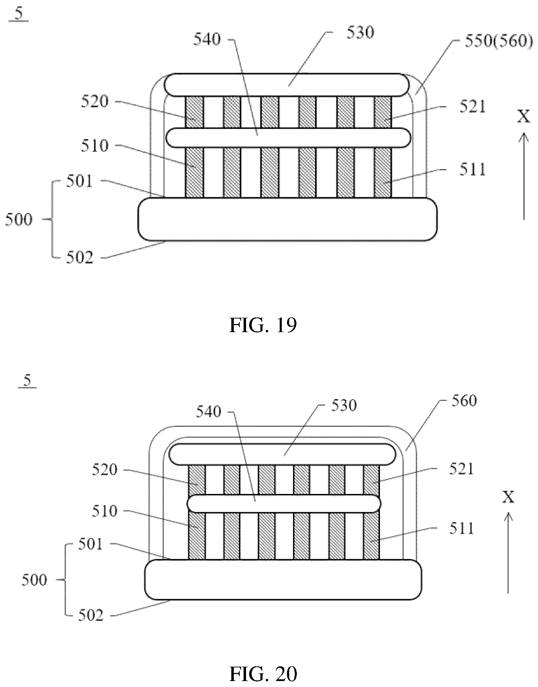

FIG. 19 is a diagram of a structure of the heat dissipation apparatus 5 according to an embodiment of this application. In a possible implementation, the heat dissipation apparatus 5 further includes a top plate 530, a partition plate 540, and a side frame 550 that are located on one side of the first surface 501, the partition plate 540 is disposed between the top plate 530 and the first surface 501 in the thickness direction X of the bottom plate, the side frame 550 surrounds a peripheral side of the partition plate 540, one end of the side frame 550 in the thickness direction X of the bottom plate is sealed with the first surface 501, and the other end of the side frame 550 in the thickness direction X of the bottom plate is sealed with the top plate 530; and the first heat dissipation device 510 is located in space enclosed by the bottom plate 500, the partition plate 540, and a part that is of the side frame 550 and that is between the bottom plate 500 and the partition plate 540, and the second heat dissipation device 520 is located in space enclosed by the partition plate 540, the top plate 530, and a part that is of the side frame 550 and that is between the partition plate 540 and the top plate 530.

In this implementation, the first heat dissipation pillars 511 are located between the first surface 501 and the partition plate 540, and the second heat dissipation pillars 521 are located between the partition plate 540 and the top plate 530. The top plate 530 forms a part of the second heat dissipation device 520, and the top plate 530 is connected to the second heat dissipation pillars 521. This helps prevent the cooling medium from leaking from the top of fins of the second heat dissipation pillars 521, improves utilization of the cooling medium, and enhances heat dissipation effect.

In this implementation, the partition plate 540 separately forms a part of the first heat dissipation device 510 and a part of the second heat dissipation device 520, and the partition plate 540 is configured to partition the heat dissipation apparatus 5 into the first heat dissipation device 510 and the second heat dissipation device 520.

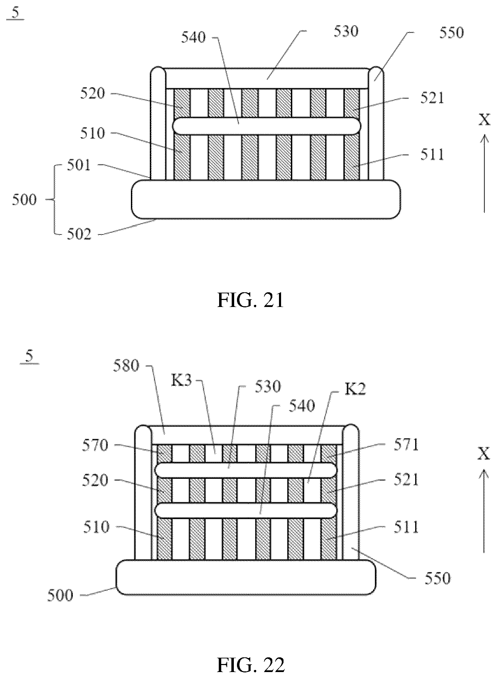

Refer to FIG. 19 to FIG. 21 together. FIG. 20 is a diagram of a structure of the heat dissipation apparatus 5 according to an embodiment of this application, and FIG. 21 is a diagram of a structure of the heat dissipation apparatus 5 according to an embodiment of this application. In this implementation, two ends of the side frame 550 are respectively sealed with the top plate 530 and the first surface 501 in the first direction X. This helps enhance stability of the heat dissipation apparatus 5, and ensures that the cooling medium is not affected by an external environment and stably functions in the heat dissipation apparatus 5. In an implementation, the side frame 550 is sealed with the top plate 530 and the first surface 501 through welding.

In the embodiment shown in FIG. 19, the side frame 550 is a water channel bottom cover 560, and penetrates the water channel bottom cover 560 in the first direction X, two ends of the water channel bottom cover 560 are respectively sealed with the top plate 530 and the first surface 501 through welding, and a material of the water channel bottom cover 560 may be different from a material of the top plate 530 and a material of the partition plate 540.

In the embodiment shown in FIG. 20, the heat dissipation apparatus 5 includes the water channel bottom cover 560; the top plate 530, the second heat dissipation device 520, the partition plate 540, and the first heat dissipation device 510 are all located in the water channel bottom cover 560; and the water channel bottom cover 560 is in a groove shape, and an opening end of the water channel bottom cover 560 is sealed with the first surface 501 through welding. The side frame 550 is a peripheral part of the water channel bottom cover 560.

In the embodiment shown in FIG. 21, the heat dissipation apparatus 5 is not additionally provided with a water channel bottom cover, the side frame 550 is welded to the top plate 530 and the first surface 501, and a material of the side frame 550 is the same as a material of the top plate 530 and a material of the partition plate 540.

In a possible implementation, the first heat dissipation pillars 511 and the bottom plate 500 are of an integrally formed structure, and the second heat dissipation pillars 521 and the partition plate 540 are of an integrally formed structure; or the first heat dissipation pillars 511, the partition plate 540, and the second heat dissipation pillars 521 are of an integrally formed structure. In this implementation, the integrally formed structure can effectively improve stability of the heat dissipation apparatus 5, so that the first heat dissipation pillars 511 and the second heat dissipation pillars 521 in the heat dissipation apparatus 5 do not shake in a process of cooling the power module 42. In addition, the integrally formed structure helps reduce processing difficulty and manufacturing costs of the heat dissipation apparatus 5.

In an implementation, the liquid inlet 590 and the liquid outlet 600 of the heat dissipation apparatus 5 are located on two sides of the side frame 550 in the seventh direction U (refer to FIG. 17e). The liquid inlet 590 and the liquid outlet 600 are connected to an external cooling system, and are configured to: input an external cooling medium into the heat dissipation apparatus 5 through the liquid inlet 590, and output the external cooling medium through the liquid outlet 600. A high-temperature cooling medium flowing out of the liquid outlet 600 is cooled by the external cooling system and then flows into the heat dissipation apparatus 5 again through the liquid inlet 590. There may be one or more liquid inlets 590 and liquid outlets 600. This may be specifically set based on a requirement.

FIG. 22 is a diagram of a structure of the heat dissipation apparatus 5 according to an embodiment of this application. In a possible implementation, the heat dissipation apparatus 5 further includes a third heat dissipation device 570, a plurality of third heat dissipation pillars 571 spaced apart are disposed in the third heat dissipation device 570, the third heat dissipation device 570 is located on a side that is of the second heat dissipation device 520 and that is away from the bottom plate 500, and after the cooling medium flows into the second heat dissipation device 520 and the third heat dissipation device 570, the flow rate in the second heat dissipation channels K2 between all the second heat dissipation pillars 521 in the second heat dissipation device 520 is greater than a flow rate in third heat dissipation channels K3 between all the third heat dissipation pillars 571 in the third heat dissipation device 570.

In this implementation, the third heat dissipation channels K3 are configured to allow the cooling medium to circulate, and volumes V3 of the third heat dissipation channels K3 are less than the volumes V2 of the second heat dissipation channels K2. The volumes V3 of the third heat dissipation channels K3 are set to be less than the volumes V2 of the second heat dissipation channels K2, so that after the cooling medium flows into the second heat dissipation device 520 and the third heat dissipation device 570, a flow rate in the third heat dissipation device 570 is less than the flow rate in the second heat dissipation device 520.

In a possible implementation, the fluid resistance of the second heat dissipation pillar 521 is less than fluid resistance of the third heat dissipation pillar 571. In this implementation, the fluid resistance of the third heat dissipation pillar 571 is resistance endured by the third heat dissipation pillar 571 from the cooling medium when the third heat dissipation pillar 571 moves relative to the cooling medium in the cooling medium.

In this implementation, shapes of the second heat dissipation pillar 521 and the third heat dissipation pillar 571 are set, so that the fluid resistance of the second heat dissipation pillar 521 is less than the fluid resistance of the third heat dissipation pillar 571.

In this embodiment, to implement that the volumes of the third heat dissipation channels K3 other than the third heat dissipation pillars 571 in the third heat dissipation device 570 are less than the volumes of the second heat dissipation channels K2 other than the second heat dissipation pillars 521 in the second heat dissipation device 520, the following structural parameters may be set: a length of the third heat dissipation device 570 in the first direction X, a length of the third heat dissipation pillar 571 in the first direction X, a spacing between third heat dissipation pillars 571, an area of a cross section of the third heat dissipation pillar 571, a volume of the third heat dissipation pillar 571, a quantity of third heat dissipation pillars 571, an arrangement manner of the third heat dissipation pillars 571, and the like. For details, refer to embodiments in FIG. 7 to FIG. 18. Details are not described herein again. In some implementations, the third heat dissipation channels K3 may alternatively be set to be greater than or equal to the second heat dissipation channels K2, but more complex structures and arrangement manners of the third heat dissipation pillars 571 and the second heat dissipation pillars 521 need to be designed, so that the flow rate in the third heat dissipation device 570 is less than the flow rate in the second heat dissipation device 520. In this implementation, to simplify a process, the volumes of the third heat dissipation channels K3 are set to be less than the volumes of the second heat dissipation channels K2. In this solution, the third heat dissipation device 570 and the third heat dissipation pillars 571 are disposed in the heat dissipation apparatus 5, so that a contact area between the cooling medium and the heat dissipation apparatus 5 can be further increased, and cooling performance of the heat dissipation apparatus 5 can be improved. In addition, space volumes in the third heat dissipation device 570, the second heat dissipation device 520, and the first heat dissipation device 510 sequentially increase, so that the cooling medium can be properly distributed in the first heat dissipation device 510, the second heat dissipation device 520, and the third heat dissipation device 570. In this way, the first heat dissipation device 510 closest to the power module 42 has best cooling effect, a temperature of the heat dissipation apparatus 5 is distributed in a gradient manner, and heat dissipation effect is better.

In an implementation, the heat dissipation apparatus 5 further includes a substrate 580, the substrate 580 and the top plate 530 are spaced apart, the substrate 580 is located on a side that is of the top plate 530 and that is away from the bottom plate 500, the side frame 550 surrounds a peripheral side of the substrate 580, the side frame 550 is sealed with the substrate 580 in the first direction X, and the third heat dissipation device 570 is located in space enclosed by the partition plate 540, the substrate 580, and a part of the side frame 550.

In an implementation, the third heat dissipation pillars 571 and the top plate 530 are of an integrally formed structure. This solution helps improve structural stability of the heat dissipation apparatus 5.

In an implementation, the heat dissipation apparatus 5 is made of a metal material such as copper. In some other implementations, the heat dissipation apparatus 5 may be made of another material with good thermal conductivity and structural strength, such as non-metal.

The foregoing describes in detail the heat dissipation apparatus, the power assembly, the power supply system, the vehicle, and the photovoltaic system provided in embodiments of this application. Specific examples are used in this specification to describe the principle and embodiments of this application, and the foregoing embodiments are merely used to help understand the method and core ideas of this application. In addition, a person of ordinary skill in the art may make modifications to the specific embodiments and the application scope based on the idea of this application. In conclusion, the content of this specification shall not be construed as a limitation on this application.

**Claims**

1. A heat dissipation apparatus, comprising a bottom plate, a first heat dissipation device, and a second heat dissipation device, wherein the bottom plate comprises a first surface and a second surface that are disposed opposite to each other, the first heat dissipation device and the second heat dissipation device are stacked on the first surface in a thickness direction of the bottom plate, the first heat dissipation device is located between the first surface and the second heat dissipation device, and the second surface is configured to fasten a power module, to dissipate heat for the power module; and
a plurality of first heat dissipation pillars spaced apart are disposed in the first heat dissipation device, a plurality of second heat dissipation pillars spaced apart are disposed in the second heat dissipation device, and after a cooling medium flows into the first heat dissipation device and the second heat dissipation device, a flow rate in first heat dissipation channels between all the first heat dissipation pillars in the first heat dissipation device is greater than a flow rate in second heat dissipation channels between all the second heat dissipation pillars in the second heat dissipation device.

2. The heat dissipation apparatus according to claim 1, wherein fluid resistance of all the first heat dissipation pillars in the first heat dissipation device is less than fluid resistance of all the second heat dissipation pillars in the first heat dissipation device.

3. The heat dissipation apparatus according to claim 1, wherein a sum of volumes of the first heat dissipation channels between all the first heat dissipation pillars is greater than a sum of volumes of the second heat dissipation channels between all the second heat dissipation pillars.

4. The heat dissipation apparatus according to claim 1, wherein the first heat dissipation device comprises a plurality of first heat dissipation pillars located at an edge, and the second heat dissipation device comprises a plurality of second heat dissipation pillars located at an edge;

the plurality of first heat dissipation pillars located at the edge of the first heat dissipation device one-to-one correspond to the plurality of second heat dissipation pillars located at the edge of the second heat dissipation device, and each first heat dissipation pillar is at least partially aligned with a corresponding second heat dissipation pillar; and
a length of the first heat dissipation device in the thickness direction of the bottom plate is greater than a length of the second heat dissipation device in the thickness direction of the bottom plate.

5. The heat dissipation apparatus according to claim 4, wherein a length of the first heat dissipation pillar in the thickness direction of the bottom plate is greater than a length of the second heat dissipation pillar in the thickness direction of the bottom plate.

6. The heat dissipation apparatus according to any one of claims 1 to 5, wherein a spacing between every two first heat dissipation pillars in the first heat dissipation device is greater than a spacing between every two second heat dissipation pillars in the second heat dissipation device.

7. The heat dissipation apparatus according to any one of claims 1 to 5, wherein an area of a cross section of the first heat dissipation pillar is less than an area of a cross section of the second heat dissipation pillar, and both the cross section of the first heat dissipation pillar and the cross section of the second heat dissipation pillar are perpendicular to the thickness direction of the bottom plate.

8. The heat dissipation apparatus according to any one of claims 1 to 5, wherein a volume of the first heat dissipation pillar is less than a volume of the second heat dissipation pillar.

9. The heat dissipation apparatus according to any one of claims 1 to 5, wherein a quantity of first heat dissipation pillars is less than a quantity of second heat dissipation pillars.

10. The heat dissipation apparatus according to any one of claims 1 to 5, wherein an orthographic projection of at least one of the plurality of first heat dissipation pillars on the first surface and an orthographic projection of at least one of the plurality of second heat dissipation pillars on the first surface are staggered.

**11.** The heat dissipation apparatus according to claim 10, wherein the plurality of first heat dissipation pillars and the plurality of second heat dissipation pillars are all regularly arranged.

**12.** The heat dissipation apparatus according to any one of claims 1 to 5, wherein the heat dissipation apparatus further comprises a top plate, a partition plate, and a side frame that are located on one side of the first surface, the partition plate is disposed between the top plate and the first surface in the thickness direction of the bottom plate, the side frame surrounds a peripheral side of the partition plate, one end of the side frame in the thickness direction of the bottom plate is sealed with the first surface, and the other end of the side frame in the thickness direction of the bottom plate is sealed with the top plate; and the first heat dissipation device is located in space enclosed by the bottom plate, the partition plate, and a part that is of the side frame and that is between the bottom plate and the partition plate, and the second heat dissipation device is located in space enclosed by the partition plate, the top plate, and a part that is of the side frame and that is between the partition plate and the top plate.

**13.** The heat dissipation apparatus according to claim 12, wherein the first heat dissipation pillars and the bottom plate are of an integrally formed structure, and the second heat dissipation pillars and the partition plate are of an integrally formed structure; or the first heat dissipation pillars, the partition plate, and the second heat dissipation pillars are of an integrally formed structure.

**14.** The heat dissipation apparatus according to any one of claims 1 to 5, wherein the heat dissipation apparatus further comprises a third heat dissipation device, a plurality of third heat dissipation pillars spaced apart are disposed in the third heat dissipation device, the third heat dissipation device is located on a side that is of the second heat dissipation device and that is away from the bottom plate, and after the cooling medium flows into the second heat dissipation device and the third heat dissipation device, the flow rate in the second heat dissipation channels between all the second heat dissipation pillars in the second heat dissipation device is greater than a flow rate in third heat dissipation channels between all the third heat dissipation pillars in the third heat dissipation device.

**15.** A power assembly, comprising a power module and the heat dissipation apparatus according to any one of claims 1 to 14, wherein the power module is fastened to the second surface.

**16.** A power supply system, comprising a power supply, an electrical device, and the power assembly according to claim 15, wherein the power supply is connected to an input end of the power module, the electrical device is connected to an output end of the power module, and the power module is configured to: convert a direct current output by the power supply into an alternating current, and transmit the alternating current to the electrical device.

**17.** A vehicle, comprising a vehicle body and the power supply system according to claim 16, wherein the power supply system is mounted on the vehicle body.

**18.** A photovoltaic system, comprising a photovoltaic module and the power assembly according to claim 15, wherein the photovoltaic module is electrically connected to the power module, and a direct current generated by the photovoltaic module is converted into an alternating current through the power module.

<u>1</u>

FIG. 1

<u>2</u>

FIG. 2

FIG. 3

FIG. 4

FIG. 5a

FIG. 5b

FIG. 6

FIG. 7

FIG. 8

FIG. 9

FIG. 10a

FIG. 10b

511

Y

FIG. 11

511

Y

FIG. 12a

521

Y

FIG. 12b

511 —

→ Y

FIG. 13

511 —

FIG. 14a

511 —

FIG. 14b

501

511 ⌐ 512(511)

FIG. 15

501

511 ⌐ 512

FIG. 16

<u>5</u>

FIG. 17a

FIG. 17b

FIG. 17c

FIG. 17d

FIG. 17e

FIG. 17f

FIG. 18

FIG. 19

FIG. 20

FIG. 21

FIG. 22

## INTERNATIONAL SEARCH REPORT

| International application No. |
|---|
| **PCT/CN2023/132920** |

**A. CLASSIFICATION OF SUBJECT MATTER**

H05K 7/20(2006.01)i

According to International Patent Classification (IPC) or to both national classification and IPC

**B. FIELDS SEARCHED**

Minimum documentation searched (classification system followed by classification symbols)

IPC:H05K

Documentation searched other than minimum documentation to the extent that such documents are included in the fields searched

Electronic data base consulted during the international search (name of data base and, where practicable, search terms used)

CJFD, CNKI, CNTXT, WPABSC, ENTXTC, ENTXT: 散热, 冷却, 柱, 第二, 层, 堆叠, 层叠, 阻力, 流阻, 体积, 流量, 电源, 功率, 车, 光伏, radiat+, cool+, heat dissipation, column, flow, layer, power

**C. DOCUMENTS CONSIDERED TO BE RELEVANT**

| Category* | Citation of document, with indication, where appropriate, of the relevant passages | Relevant to claim No. |
|---|---|---|
| Y | CN 110543069 A (CORETRONIC CORP.) 06 December 2019 (2019-12-06) description, paragraphs 12-47, and figure 1 | 1-18 |
| Y | CN 217606806 U (BYD CO., LTD.) 18 October 2022 (2022-10-18) description, paragraphs 42-45 | 1-18 |
| Y | CN 115101498 A (HUAWEI DIGITAL ENERGY TECHNOLOGY CO., LTD.) 23 September 2022 (2022-09-23) description, paragraphs 29 and 31-33 | 16-18 |
| A | CN 113316370 A (SUZHOU INOVANCE AUTOMOTIVE CO., LTD.) 27 August 2021 (2021-08-27) entire document | 1-18 |
| A | CN 114093832 A (GUANGDONG XINJU'NENG SEMICONDUCTOR CO., LTD.) 25 February 2022 (2022-02-25) entire document | 1-18 |
| A | CN 206136542 U (BEIJING NEGO AUTOMATION TECHNOLOGY CO., LTD. et al.) 26 April 2017 (2017-04-26) entire document | 1-18 |

☑ Further documents are listed in the continuation of Box C.     ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **13 December 2023** | **21 December 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

International application No.

**PCT/CN2023/132920**

### C.    DOCUMENTS CONSIDERED TO BE RELEVANT

| Category* | Citation of document, with indication, where appropriate, of the relevant passages | Relevant to claim No. |
|---|---|---|
| A | CN 215008207 U (BYD SEMICONDUCTOR CO., LTD.) 03 December 2021 (2021-12-03) entire document | 1-18 |
| A | CN 217444376 U (BYD SEMICONDUCTOR CO., LTD.) 16 September 2022 (2022-09-16) entire document | 1-18 |
| A | US 2021210411 A1 (LG ELECTRONICS INC.) 08 July 2021 (2021-07-08) entire document | 1-18 |

Form PCT/ISA/210 (second sheet) (July 2022)

**INTERNATIONAL SEARCH REPORT**
Information on patent family members

International application No.

**PCT/CN2023/132920**

| Patent document cited in search report | | | Publication date (day/month/year) | Patent family member(s) | | | Publication date (day/month/year) |
|---|---|---|---|---|---|---|---|
| CN | 110543069 | A | 06 December 2019 | US | 2019360764 | A1 | 28 November 2019 |
| | | | | US | 10976116 | B2 | 13 April 2021 |
| | | | | TWI | 673466 | B | 01 October 2019 |
| | | | | TW | 202004112 | A | 16 January 2020 |
| CN | 217606806 | U | 18 October 2022 | None | | | |
| CN | 115101498 | A | 23 September 2022 | None | | | |
| CN | 113316370 | A | 27 August 2021 | WO | 2022253241 | A1 | 08 December 2022 |
| CN | 114093832 | A | 25 February 2022 | None | | | |
| CN | 206136542 | U | 26 April 2017 | None | | | |
| CN | 215008207 | U | 03 December 2021 | None | | | |
| CN | 217444376 | U | 16 September 2022 | None | | | |
| US | 2021210411 | A1 | 08 July 2021 | EP | 3846203 | A1 | 07 July 2021 |
| | | | | KR | 20210088329 | A | 14 July 2021 |

Form PCT/ISA/210 (patent family annex) (July 2022)

38

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202223453727